# EUROPEAN PATENT SPECIFICATION

(11) **EP 4 478 864 B1**
(45) Date of publication and mention of the grant of the patent: **13.05.2026**
(21) Application number: 24166880.5
(22) Date of filing: 27.03.2024
(51) Int. Cl.: H10K 59/35, H10K 59/131, H10K 59/80, H10K 102/00

(54) **LIGHT EMITTING DISPLAY DEVICE**
LICHTEMITTIERENDE ANZEIGEVORRICHTUNG
DISPOSITIF D'AFFICHAGE ÉLECTROLUMINESCENT

(30) Priority: 16.06.2023 KR 20230077375
(43) Date of publication of application: 18.12.2024
(73) Proprietor: Samsung Display Co., Ltd., Yongin-si, Gyeonggi-do 17113 (KR)
(72) Inventor: Lee, Sang Shin, Giheung-gu, Yongin-si, Gyeonggi-do 17113 (KR); Kang, Yeonju, Giheung-gu, Yongin-si, Gyeonggi-do 17113 (KR); Kim, Sanghoon, Giheung-gu, Yongin-si, Gyeonggi-do 17113 (KR); Lee, Seung Jin, Giheung-gu, Yongin-si, Gyeonggi-do 17113 (KR); Lee, Yuri, Giheung-gu, Yongin-si, Gyeonggi-do 17113 (KR); Jang, Minji, Giheung-gu, Yongin-si, Gyeonggi-do 17113 (KR)
(74) Representative: Dr. Weitzel & Partner

(56) References cited:
- WO-A1-2023/024901
- WO-A1-2023/052908
- US-A1- 2022 344 440

## Description

### BACKGROUND

### 1. Field

The present invention relates to a light emitting display device.

### 2. Description of the Related Art

A display device is a device that includes a screen or display panel that displays images, and includes a liquid crystal display (LCD), an organic light emitting diode (OLED), and the like.

Such display devices are used in various electronic devices such as mobile phones, navigation devices, digital cameras, electronic books, portable game consoles, and terminals.

Organic light emitting display devices generally have self-luminance characteristics and, unlike a liquid crystal display devices, generally do not require a separate light source, so the thickness and weight can be relatively reduced. In addition, organic light emitting diode displays have relatively high-quality characteristics such as relatively low power consumption, relatively high luminance, and relatively fast response speed.

The above information disclosed in this Background section is only for enhancement of understanding of the background and therefore the information discussed in this Background section does not necessarily constitute prior art.

US2022344440A1 relates to a display device wherein electrical connections are done by a laser light based drilling process to expose a portion of a conducive layer below.

WO2023024901 A1 relates to a display device comprising a plurality of openings and recesses to allow space for connection holes.

WO2023052908A1 relates to a display device comprising a plurality of pixel geometries spanning from rectangular shapes with rounded corners, triangular shapes with rounded corners to hexagonal shapes.

### SUMMARY

The present invention provides a light emitting display device with an increased space between adjacent light emitting layers for removing an insulation layer by laser irradiation, especially for electrically connecting a cathode with an underlying electrical layer such as a connection electrode.

The invention may provide a high-resolution light emitting display device.

The invention provides a light emitting display device in which light emitting devices of the same color have the same lifetime.

A light emitting display device according to the present invention comprises a unit pixel group having at least two unit pixels, wherein a unit pixel from among the at least two unit pixels includes a first light emitting layer, a second light emitting layer, and a third light emitting layer corresponding to three primary colors, the first light emitting layer includes two sub-light emitting layers in one unit pixel, at least one laser drilling position formed in the unit pixel group, the unit pixel group comprises first second and third light emitting layers adjacent to the laser drilling position and at least second and third light emitting layers spaced apart from the laser drilling position, at least the second light emitting layer and the third light emitting layer adjacent to the laser drilling position includes a recess, the size of an area of the second light emitting layer adjacent to the laser drilling position and the size of an area of the second light emitting layer spaced apart from the laser drilling position have an area difference of greater than 0% and of less than 10%, and the size of an area of the third light emitting layer adjacent to the laser drilling position and the size of an area of the third light emitting layer spaced apart from the laser drilling position have an area difference of greater than 0% and of less than 10%.

The recess in the light emitting layer adjacent the laser drilling position especially is larger than any other reduced corner area of another or the same light emitting layer, which other corner area is reduced due to the form of a rounded a chamfered corner.

The at least one recess or each recess facing the laser drilling position may have a concave shape, especially a circular arc shape, preferably concentric to a center of the laser drilling position and/or an outer circumference of the laser drilling position, in a plan view.

A light emitting display device according to some embodiments includes one unit pixel group composed of at least two unit pixels, one unit pixel including a first light emitting layer, a second light emitting layer, and a third light emitting layer corresponding to three primary colors, the first light emitting layer including two first light emitting layers in one unit pixel, a laser drilling position is formed in a part of the unit pixel group, and the second light emitting layer and the third light emitting layer adjacent to the laser drilling position include a second modified light emitting layer including a recess, the second and third normal light emitting layers are formed of a third modified light emitting layer, and the second and third light emitting layers are formed of a second normal light emitting layer and a third normal light emitting layer that do not include recesses, and the area of the second modified light emitting layer and the area of the second normal light emitting layer have an area difference of greater than 0% and of less than 10%, and the area of the third modified light emitting layer and the area of the third normal light emitting layer have an area difference of greater than 0% and of less than 10%. Thus, according in the present disclosure, the light emitting layers having a recess at a side, especially a corner thereof, as seen in a plan view, are termed as modified light emitting layers, whereas light emitting layers without such a recess or termed as normal light emitting layers. However, as can be seen from the present disclosure, also the normal light emitting layers may have chamfered or rounded corners of a in general rectangular shape, as seem in a plan view.

According to some embodiments, the recesses of the second modified light emitting layer and the recesses of the third modified light emitting layer are respectively formed at a side of the laser drilling position of the second modified light emitting layer and that of the third modified light emitting layer.

According to some embodiments, the second modified light emitting layer may be extended at a side portion of the second normal light emitting layer, the recesses of the second modified light emitting layer may be reduced at a corner portion of the second normal light emitting layer, the third modified light emitting layer may be extended at a side portion of the third normal light emitting layer, and the recesses of the third modified light emitting layer may be narrowed at a corner portion of the third normal light emitting layer.

According to some embodiments, planar shapes of the second normal light emitting layer and the third normal light emitting layer may have a quadrangle shape, and corners may have chamfered or rounded corners.

According to some embodiments, the first light emitting layer is formed of a first normal light emitting layer that does not contain recesses, and the first light emitting layer included in the unit pixel includes a first-1 light emitting layer and a first-2 light emitting layer, and the first-1 light emitting layer and the first-2 light emitting layer have a rectangular shape in a flat shape, and the corner portion is away or has round corners, the direction in which the first light emitting layer is arranged and the direction in which the first and second light emitting layers are arranged may be different.

According to some embodiments, included in one unit pixel, a light emitting device including the first-1 light emitting layer and a light emitting device including the first-2 light emitting layer may be electrically connected to the same pixel driving unit through a connection line.

According to some embodiments, when all of the laser drilling positions are positioned in the one unit pixel, a portion of the connection line may extend along the periphery of the unit pixel.

According to some embodiments, the first light emitting layer adjacent to the laser drilling position is formed as a first modified light emitting layer that includes a recess, and the aforementioned first light emitting layer located away from the laser drilling position is formed as a first normal light emitting layer that does not include a recess, the area of the first modified light emitting layer and the area of the first normal light emitting layer has an area difference of greater than 0% and of 10% or less.

According to some embodiments, each of the first normal light emitting layers has a rectangular shape in a planar shape, corners are chamfered or rounded, and two first modified light emitting layers are included in one unit pixel, and the two first modified light emitting layers may have different elongated directions.

According to some embodiments, the second modified light emitting layer may additionally extend even at a corner portion of the second normal light emitting layer, and the third modified light emitting layer may additionally extend also at a corner portion of the third normal light emitting layer.

According to some embodiments, the one unit pixel group may include four unit pixels, and the laser drilling position may be positioned across all four unit pixels.

According to some embodiments, the center of the laser drilling position may be positioned at one of the four unit pixels.

According to some embodiments, the center of the laser drilling position may be positioned at a point where the four unit pixels meet.

According to some embodiments, the one unit pixel group may include four unit pixels, and the laser drilling position may be positioned across two of the four unit pixels.

According to some embodiments, the one unit pixel group may include four unit pixels, and the laser drilling position may be positioned in one of the four unit pixels.

According to some embodiments, the laser drilling positions may be different from each other in at least two different unit pixel groups.

According to some embodiments, a light emitting display device includes one unit pixel group including at least two unit pixels, one unit pixel including a first light emitting layer, a second light emitting layer, and a third light emitting layer corresponding to three primary colors, wherein the first light emitting layer includes two first light emitting layers in one unit pixel, a laser drilling position is formed in a part of the unit pixel group, the first light emitting layer is formed of a first normal light emitting layer not including a recess, and the second light emitting layer and the third light emitting layer are formed of a second modified light emitting layer and a third modified light emitting layer including recesses.

According to some embodiments, among the second modified light emitting layer and the third modified light emitting layer adjacent to the laser drilling position, the recess may be formed at a side of the laser drilling position of the second modified light emitting layer and the third modified light emitting layer, respectively.

According to some embodiments, the second modified light emitting layer and the third modified light emitting layer positioned apart from the laser drilling position may be positioned on a side different from a side on which the recess is positioned in the second modified light emitting layer and the third modified light emitting layer adjacent to the laser drilling position, respectively.

According to some embodiments, the one unit pixel group includes four unit pixels, the second modified light emitting layer and the third modified light emitting layer have a rectangular shape except for the recess, and have chamfered or rounded corners, each of the second modified light emitting layer and the third modified light emitting layer are included in the one unit pixel group, each of the second modified light emitting layer and the third modified light emitting layer adjacent to the laser drilling position is one, and the second modified light emitting layer is spaced apart from the laser drilling position, and the third modified light emitting layers, respectively, and corners where the recesses are positioned in the second and third modified light emitting layers adjacent to the laser drilling position and corners at which the recesses are positioned in the second and third modified light emitting layers spaced apart from the laser drilling position may all be different.

According to some embodiments, a structure for applying power to a cathode, such as laser drilling, may be formed across adjacent unit pixels, and thus, despite a reduced area, light emitting devices of the same color may have the same area and the same lifetime. The planar shape of at least one light emitting device may be changed.

According to some embodiments, a high-resolution light emitting display device may be provided by preventing a user from seeing a low resolution by preventing light emitting regions or light emitting devices of the same color from being located adjacent to each other in two adjacent unit pixels.

### BRIEF DESCRIPTION OF THE DRAWINGS

FIG. 1 is a top plan view illustrating light emitting devices and a laser drilling position in a light emitting display device according to some embodiments.
FIG. 2 to FIG. 5 are drawings for explaining the planar shape of the modified light emitting layer according to the embodiments of FIG. 1.
FIG. 6 is a drawing explaining the distance between light emitting layers in a comparative example.
FIG. 7 is a drawing explaining the spacing between light emitting layers in the embodiments of FIG. 1.
FIG. 8 and FIG. 9 are tables showing characteristics of each comparative example and some embodiments.
FIG. 10 is a cross-sectional view of a light emitting display device according to some embodiments.
FIG. 11 to FIG. 23 are drawings showing further details according to some embodiments.
FIG. 24 is a schematic top plan view of a lower portion of light emitting devices of a light emitting display device according to some embodiments.
FIG. 25 is a circuit drawing of a pixel of a light emitting display device according to some embodiments.
FIG. 26 is a block drawing of an electronic device according to some embodiments.

### DETAILED DESCRIPTION

Hereinafter, with reference to the accompanying drawings, aspects of some embodiments will be described in more detail so that those skilled in the art can carry out embodiments according to the present disclosure.

Embodiments according to the present disclosure may be embodied in many different forms and is not limited to the embodiments set forth herein.

In order to more clearly describe the embodiments, some description of some parts or components that is not necessary to enable a person having ordinary skill in the art to make and use the embodiments according to the present disclosure may be omitted, and the same reference numerals are assigned to the same or similar constituent elements throughout the specification.

Also, the size and thickness of each component shown in the drawings are arbitrarily represented for the convenience of explanation, so embodiments according to the present disclosure are not necessarily limited to that what is shown.

In the drawings, the thickness is shown enlarged to clearly express the various layers and regions.

In the drawings, for convenience of explanation, the thicknesses of some layers and regions are exaggerated.

Also, when a part such as a layer, film, region, plate, or component is said to be "above" or "on" another part, this includes not only the case where it is "directly on" the other part, but also the case where there is another part in between.

Conversely, when a part is said to be "directly on" another part, it means that there is no other part in between.

In addition, being "above" or "on" a reference part means being positioned above or below the reference part, and does not necessarily mean being positioned "above" or "on" it in a direction opposite to gravity.

In addition, throughout the specification, when a certain component is said to "include," it means that it may further include other components without excluding other components unless otherwise stated.

In addition, throughout the specification, when reference is made to "planar image," it means when the target part is viewed from above, and when reference is made to "cross-sectional image," it means when a cross-section of the target part cut vertically is viewed from the side.

In addition, throughout the specification, when reference is made to "connected," this does not mean only the case where two or more components are directly connected, but also when two or more constituent elements are indirectly connected through another component, when physically connected or electrically connected, as well as when referred to by different names according to positions or functions, but may include connecting substantially integral parts to each other.

In addition, throughout the specification, when a part such as a wire, layer, film, region, plate, or component "extends in a first direction or a second direction," it does not mean only a straight line extending in the corresponding direction, but also includes a structure extending generally along the first or second direction, a structure that is bent at one part, has a zigzag structure, or a structure that extends while including a curved structure.

In addition, electronic devices (e.g., mobile phones, TVs, monitors, and notebook computers) including display devices and display panels described in the specification or electronic devices including display devices and display panels manufactured by the manufacturing method described in the specification are not excluded from the scope of the present specification.

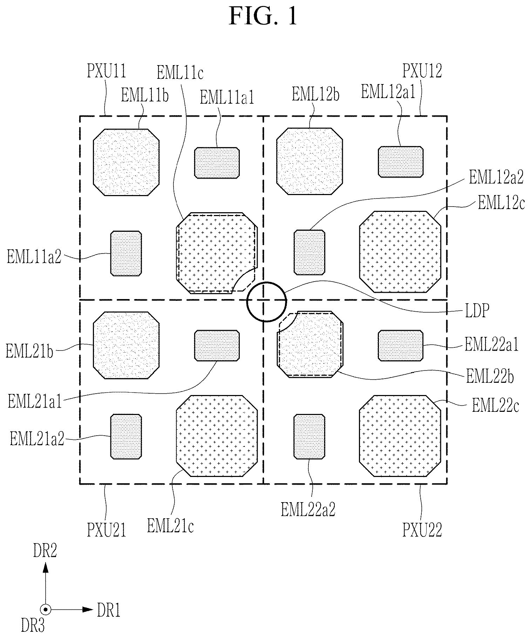

First, a planar structure of four unit pixels included in a light emitting display device will be described with respect to FIG. 1.

FIG. 1 is a top plan view illustrating light emitting devices and a laser drilling position in a light emitting display device according to some embodiments.

In FIG. 1, dotted lines schematically show planar positions of the unit pixels PXU11, PXU12, PXU21, and PXU22.

Four unit pixels PXU11, PXU12, PXU21, and PXU22 illustrated in FIG. 1 may constitute one unit pixel group.

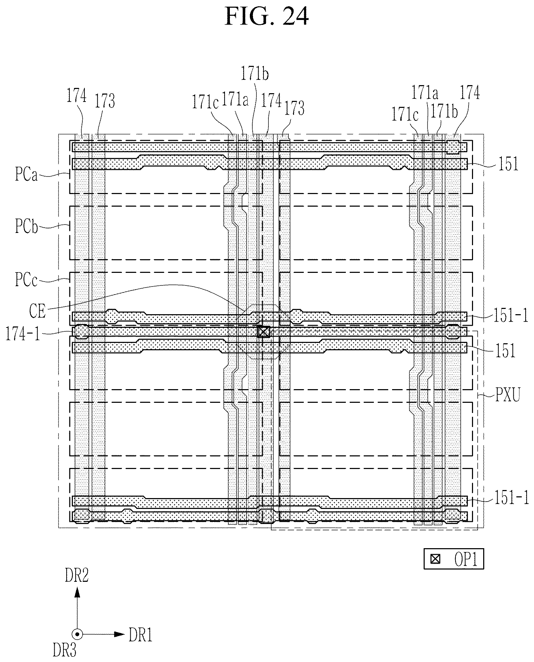

Each of the unit pixels PXU11, PXU12, PXU21, and PXU22 can include three pixel driving parts (or pixel driving units) (refer to PCa, PCb, and PCc in FIG. 24) as described later with respect to FIG. 24, and three pixel driving parts PCa, PCb, and PCc are formed on the substrate, and four light emitting devices can be located on it as shown in FIG. 1.

Each light emitting device may include an anode, a light emitting layer, and a cathode, and in FIG. 1, the anode and cathode are omitted, and the planar shapes of each light emitting layer EML11a1, EML12a1, EML21a1, EML22a1, EML11a2, EML12a2, EML21a2, EML22a2, EML11b, EML12b, EML21b, EML22b, EML11c, EML12c, EML21c, EML22c are shown.

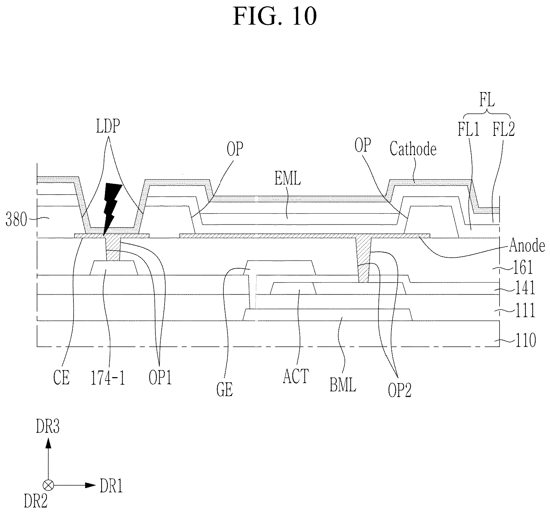

The planar shape of each light emitting layer EML11a1, EML12a1, EML21a1, EML22a1, EML11a2, EML12a2, EML21a2, EML22a2, EML11b, EML12b, EML21b, EML22b, EML11c, EML12c, EML21c, EML22c shown in FIG. 1 constitutes a light emitting area. It may correspond to the planar shape of the light emitting device or the shape of the opening (see OP in FIG. 10) of the pixel defining layer (see 380 in FIG. 10).

For example, the opening OP of the pixel defining layer 380 exposes at least a portion of the anode, and within the opening OP of the pixel defining layer 380, each light emitting layer EML11a1, EML12a1, EML21a1, EML22a1, EML11a2, EML12a2, EML21a2, EML22a2, EML11b, EML12b, EML21b, ML22b, EML11c, EML12c, EML21c, EML22c may be positioned.

As a result, the light emitting layers EML11a1, EML12a1, EML21a1, EML22a1, EML11a2, EML12a2, EML21a2, EML22a2, EML11b, EML12b, EML21b, EML22b, EML11c, EML12c, EML21c, EML22c may have the same planar shape as the planar shape of the opening OP.

Here, each of the light emitting layers EML11a1, EML12a1, EML21a1, EML22a1, EML11a2, EML12a2, EML21a2, EML22a2, EML11b, EML12b, EML21b, EML22b, EML11c, EML12c, EML21c, EML22c may include at least one of quantum dot materials according to some embodiments.

The pixel defining layer 380 and the light emitting layers EML11a1, EML12a1, EML21a1, EML22a1, EML11a2, EML12a2, EML21a2, EML22a2, EML11b, EML12b, EML21b, EML22b, EML11c, EML12c, EML21c, EML22c are shown in FIG. 10. In reference thereto, it may be covered with an integrally formed cathode (see cathode in FIG. 10).

The first light emitting layer EML11a1, EML12a1, EML21a1, EML22a1, EML11a2, EML12a2, EML21a2, EML22a2 may emit a first color, the second light emitting layer EML11b, EML12b, EML21b, EML22b may emit a second color, and the third light emitting layer EML11c, EML12c, EML21c, EML22c may emit a third color. The first light emitting layers EML11a1, EML12a1, EML21a1, EML22a1, EML11a2, EML12a2, EML21a2, EML22a2 may be divided into first-1 light emitting layers EML11a1, EML12a1, EML21a1, EML22a1 and first-2 light emitting layers EML11a2, EML12a2, EML21a2, EML22a2. That is, each unit pixel PXU11, PXU12, PXU21, and PXU22 may include two parts of a first light emitting layer EML11a1, EML12a1, EML21a1, EML22a1, EML11a2, EML12a2, EML21a2, EML22a2 and the two parts in each unit pixel PXU11, PXU12, PXU21, and PXU22 are termed as first-1 light emitting layers EML11a1, EML12a1, EML21a1, EML22a1 for the first part and first-2 light emitting layers EML11a2, EML12a2, EML21a2, EML22a2 for the second part. Thus, the first-1 light emitting layers EML11a1, EML12a1, EML21a1, EML22a1 may also be termed as "first-first" light emitting layers or as first sub-light emitting layers and the first-2 light emitting layers EML11a2, EML12a2, EML21a2, EML22a2 may also be termed as "second-first" light emitting layers or as second sub-light emitting layers. Therefore, each first light emitting layer EML11a1, EML12a1, EML21a1, EML22a1, EML11a2, EML12a2, EML21a2, EML22a2 comprises the first sub-light emitting layer and the second sub-light emitting layer. In the following the terms first-1 and first-2 light emitting layer are used in this connection.

Here, the first light emitting layer can emit red light, the second light emitting layer can emit green light, and the third light emitting layer can emit blue light.

However, according to some embodiments, the first light emitting layer divided into two light emitting layers (first-1 light emitting layer and first-2 light emitting layer) may emit blue or green light, and the remaining two lights may correspond to the second light emitting layer and the third light emitting layer, respectively.

Also, according to some embodiments, light of three primary colors other than red, green, and blue light may be emitted.

Within each unit pixel PXU11, PXU12, PXU21, PXU22, the second light emitting layer EML11b, EML12b, EML21b, EML22b and the third light emitting layer EML11c, EML12c, EML21c, EML22c are arranged in the first diagonal direction, and the first-1 light emitting layer EML11a1, EML12a1, EML21a1, EML22a1 and the first-2 light emitting layer EML11a2, EML12a2, EML21a2, EML22a2 can be arranged in the second diagonal direction intersecting with the first diagonal direction.

Here, the first oblique direction is a direction between the reverse direction of the first direction DR1 and the second direction DR2, and may have an angle of 45 degrees with the reverse direction of the first direction DR1 or the second direction DR2.

Meanwhile, the second oblique direction is a direction between the first direction DR1 and the second direction DR2, and may have an angle of 45 degrees with the first direction DR1 or the second direction DR2.

Each of the three pixel driving units PCa, PCb, and PCc is electrically connected to a first light emitting device including the first light emitting layers EML11a1, EML12a1, EML21a1, EML22a1, EML11a2, EML12a2, EML21a2, and EML22a2, or a second light emitting device including the second light emitting layers EML11b, EML12b, EML21b, and EML22ba third light emitting device including the third light emitting layer EML11c, EML12c, EML21c, EML22c.

Meanwhile, the pixel driving part connected to the first light emitting device is electrically connected to both a first-1 light emitting device, which includes the first-1 light emitting layer EML11a1, EML12a1, EML21a1, EML22a1, and a first-2 light emitting device, which includes the first-2 light emitting layer EML11a2, EML12a2, EML21a2, EML22a2, and at this time, the first-1 light emitting device and the first-2 light emitting device can be connected in parallel.

However, according to some embodiments, they may be connected in series.

Referring to FIG. 1, a laser drilling position LDP is also shown.

In FIG. 1, the laser drilling position LDP is formed around the corner where all unit pixels PXU11, PXU12, PXU21, and PXU22 meet in one unit pixel group, and is formed over all unit pixels PXU11, PXU12, PXU21, and PXU22.

In addition, in the embodiments of FIG. 1, the center of the laser drilling position LDP does not coincide with the boundaries of the four unit pixels PXU11, PXU12, PXU21, and PXU22, and in the embodiments of FIG. 1, the center of the laser drilling position LDP is positioned within the unit pixel PXU22.

This may be because the laser drilling position LDP is positioned far from the largest light emitting layer EML11c among the four adjacent light emitting layers EML11c, EML12a2, EML21a1, and EML22b.

A connecting electrode (see CE in FIG. 24) to which a voltage to be provided to the cathode is applied is positioned below the laser drilling position LDP.

Laser drilling electrically connects the connecting electrode CE and a cathode formed as a whole by irradiating a laser to melt an insulating layer positioned between the two.

At this time, when the area of the portion melted by the laser is large and the laser is irradiated to the light emitting layer, the anode and/or other conductors, a short-circuit may occur and the pixel may malfunction.

Therefore, to the present invention allocates a certain area for laser drilling without irradiating the laser to the light emitting layer, the anode and/or other conductors.

In the embodiments of FIG. 1, the two light emitting layers EML11c and EML22b located adjacent to the laser drilling position LDP are formed in a structure having a concave recess to maintain a distance from the laser drilling position LDP.

The light emitting layer EML11a1, EML12a1, EML21a1, EML22a1, EML11a2, EML12a2, EML21a2, EML22a2, EML11b, EML12b, EML21b, EML22b, EML11c, EML12c, EML21c, EML22c can be divided into a normal light emitting layer EML11a1, EML12a1, EML21a1, EML22a1, EML11a2, EML12a2, EML21a2, EML22a2, EML11b, EML12b, EML21b, EML12c, EML21c, EML22c that does not include a significantly concave recess, and a modified light emitting layer EML11c, EML22b that includes a recess.

Here, the normal light emitting layer may be spaced apart (or positioned away) from the laser drilling position LDP, and the modified light emitting layer may be positioned adjacent to the laser drilling position LDP.

The first light emitting layer (hereinafter referred to as a first normal light emitting layer) EML11a1, EML12a1, EML21a1, EML22a1, EML11a2, EML12a2, EML21a2, EML22a2 not including recesses has a rectangular planar shape, and may have a structure with chamfered or rounded corners.

Some of the first normal light emitting layers EML11a1, EML12a1, EML21a1, EML22a1, EML11a2, EML12a2, EML21a2, EML22a2, namely the first-1 normal light emitting layers EML11a1, EML12a1, EML21a1, EML22a1, are arranged to be elongated in the first direction DR1, and the others of the first normal light emitting layers EML11a1, EML12a1, EML21a1, EML22a1, EML11a2, EML12a2, EML21a2, EML22a2, namely the first-2 normal light emitting layers EML11a2, EML12a2, EML21a2, and EML22a2, may be arranged to be elongated in the second direction DR2.

On the other hand, the second light emitting layer (hereinafter referred to as the second normal light emitting layer) EML11b, EML12b, EML21b that does not include recesses has a square planar shape and may have a structure in which corners are chamfered or rounded.

Hereinafter, chamfered embodiments will be mainly explained.

In addition, the third light emitting layer (hereinafter also referred to as the third normal light emitting layer) EML12c, EML21c, EML22c without recesses may have a square planar shape and a structure with chamfered or rounded corners.

Hereinafter, chamfered embodiments will be mainly explained.

In the embodiments of FIG. 1, the second normal light emitting layer EML11b, EML12b, EML21b is formed with a relatively smaller area than the third normal light emitting layer EML12c, EML21c, EML22c.

However, according to some embodiments, the areas may be the same or the second normal light emitting layer EML11b, EML12b, EML21b may have a larger area.

According to some embodiments, the first normal light emitting layer EML11a1, EML12a1, EML21a1, EML22a1, EML11a2, EML12a2, EML21a2, EML22a2, the second normal light emitting layer EML11b, EML12b, EML21b, and the third normal light emitting layer EML12c, EML21c, EML22c can have a polygonal shape such as a triangle or a circular or elliptical shape, and in the case of a polygon, the edges may be chamfered or have rounded corners.

Meanwhile, the modified light emitting layer EML11c, EML22b including the recess is positioned adjacent to the laser drilling position LDP, and includes a recess to maintain a certain distance from the position of the laser drilling position LDP.

In FIG. 1, the third modified light emitting layer EML11c, EML 22b located in the unit pixel PXU11 and the second modified light emitting layer EML22b located in the unit pixel PXU22 are shown as solid lines, and a dotted line overlapping them is also shown.

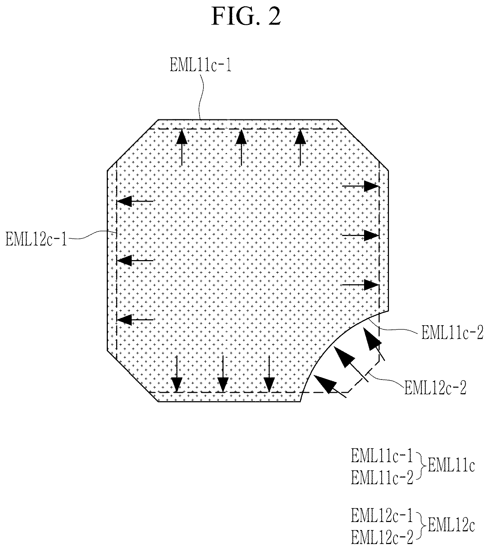

Here, the dotted line represents the size of the third normal light emitting layer (EML12c, EML21c, EML22c) and the second normal light emitting layer (EML11b, EML12b, EML21b) positioned in different parts; for example, it is explained through FIG. 2 to FIG. 5.

FIG. 2 to FIG. 5 are drawings for explaining the planar shape, that is the shape in a plan view, of the modified light emitting layer according to the embodiments of FIG. 1.

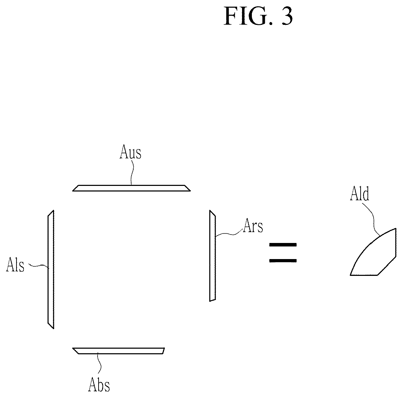

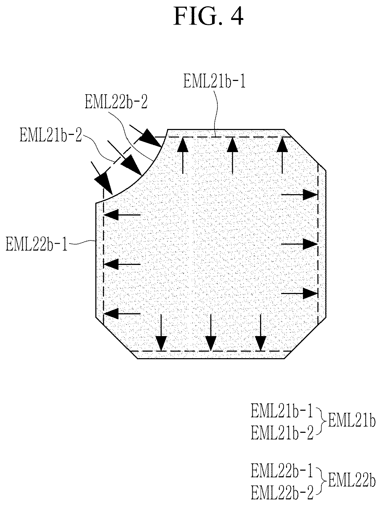

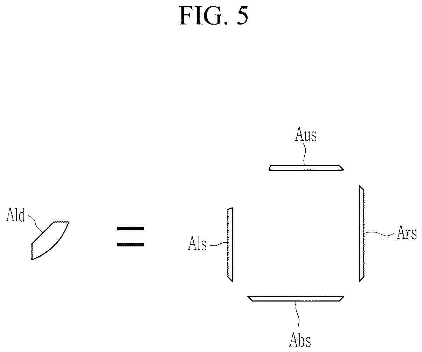

FIG. 2 and FIG. 3 are plan views of the third light emitting layer EML11c located in the unit pixel PXU11, and FIG. 4 and FIG. 5 are plan views of the second light emitting layer EML22b located in the unit pixel PXU22.

First, a planar shape of the third light emitting layer EML11c positioned in the unit pixel PXU11 will be described through FIG. 2 and FIG. 3.

In FIG. 2, the third modified light emitting layer EML11c positioned in the unit pixel PXU11 is shown as a solid line.

In addition, in FIG. 2, the third normal light emitting layer EML12c positioned in the unit pixel PXU12 is also indicated by a dotted line.

In FIG. 2, the dotted line and the solid line are shown as a solid line while overlapping the two lines at the corner portion.

In FIG. 2, reference numerals are assigned to different parts except for a corner portion where the solid line of the third modified light emitting layer EML11c and the dotted line of the third normal light emitting layer EML12c overlap.

For example, in the third modified light emitting layer EML11c, reference numerals are assigned to the side portion EML11c-1 and the recess portion EML11c-2, and in the third normal light emitting layer EML12c, reference numerals are assigned to the side portion EML12c-1 and the corner portion EML12c-2 corresponding to the recess portion EML11c-2 of the third modified light emitting layer EML11c.

An arrow, shown in FIG. 2, shows a direction in which deformation occurs in the third normal light emitting layer EML12c, and is changed to the third modified light emitting layer EML11c.

That is, it extends from the side portion EML12c-1 of the third normal light emitting layer EML12c to the side portion EML11c-1 of the third modified light emitting layer EML11c, and contracts from the corner portion EML12c-2 of the third normal light emitting layer EML12c to the recess portion EML11c-2 of the third modified light emitting layer EML11c.

A relationship between the areas of the third normal light emitting layer EML12c is shown in FIG. 2, and the third modified light emitting layer EML11c is shown in FIG. 3.

In FIG. 3, only the portion where the third modified light emitting layer EML11c is wider than the third normal light emitting layer EML12c is shown on the left side, and only the portion where the third normal light emitting layer EML12c is wider than the third normal light emitting layer EML11c is shown on the right side.

The area located on the left side of FIG. 3 is the area between the edge part EML11c-1 of the third modified light emitting layer EML11C-1 and the edge part EML12c-1 of the third normal light emitting layer EML12c. It is distinguished and displayed as the upper area Aus located on the top, the lower area Abs located at the bottom, the left area Als located on the left, and the right area Ars located on the right.

In FIG. 3, the portion located on the right side is the area between the corner portion EML12c-2 of the third normal light emitting layer EML12c and the recess portion EML11c-2 of the third modified light emitting layer EML11c, and is shown as the recess side area Ald.

An equal sign, shown in the center of FIG. 3, indicates that the total sum of areas shown on the left side of FIG. 3 and the area shown on the right side of FIG. 3 are equal to each other.

Therefore, since the third modified light emitting layer EML11c and the third normal light emitting layers EML12c, EML21c, and EML22c all have the same area (or size of area), and the lifespan of the light emitting layer is proportional to the planar area of the light emitting layer, all the third light emitting layers EML11c, EML12c, EML21c, and EML22c may have the same lifespan.

The area of the third light emitting layers EML11c, EML12c, EML21c, and EML22c may be formed in various ways according to the material constituting the light emitting layer.

Meanwhile, a difference in area between the two sides may occur due to dispersion or errors that may occur in the actual manufacturing process.

Here, the position of the edge of the light emitting layer may vary within 1 µm due to dispersion or error, and the area difference that may occur between the normal light emitting layer and the modified light emitting layer due to dispersion or error may have an area difference of up to 10%.

Although a difference in lifespan of the light emitting layer may occur due to the difference in area, this difference in lifespan may be negligible.

Meanwhile, hereinafter, the planar shape of the second light emitting layer EML22b positioned in the unit pixel PXU22 will be described through FIG. 4 and FIG. 5.

In FIG. 4, the second modified light emitting layer EML22b positioned in the unit pixel PXU22 is shown as the modified light emitting layer, and the second modified light emitting layer EML22b is shown as a solid line.

In addition, in FIG. 4, the normal light emitting layer is also indicated by a dotted line, and the second normal light emitting layer EML21b positioned in the unit pixel PXU21 is shown.

In FIG. 4, the dotted line and the solid line are shown as a solid line while overlapping the two lines at the corner portion.

In FIG. 4, reference numerals are assigned to different parts except for a corner portion where the solid line of the second modified light emitting layer EML22b and the dotted line of the second normal light emitting layer EML21b overlap.

For example, reference numerals are assigned to the side portion EML22b-1 and recess portion EML22b-2 of the second modified light emitting layer EML22b, and reference numerals are assigned to the side portion EML21b-1 of the second normal light emitting layer EML21b and the corner portion EML21b-2 corresponding to the recess portion EML22b-2 of the second modified light emitting layer EML22b.

An arrow, shown in FIG. 4, shows a direction in which deformation occurs in the second normal light emitting layer EML21b and is changed to the second modified light emitting layer EML22b.

That is, it extends from the side portion EML21b-1 of the second normal light emitting layer EML21b to the side portion EML22b-1 of the second modified light emitting layer EML22b, and contracts from the corner portion EML21b-2 of the second normal light emitting layer EML21b to the recess portion EML22b-2 of the second modified light emitting layer EML22-b.

A relationship between the areas of the second normal light emitting layer EML21b is shown in FIG. 4, and the second modified light emitting layer EML22b is shown in FIG. 5.

In FIG. 5, on the right side, it is shown that the second modified light emitting layer EML22b is formed wider than the second normal light emitting layer EML21b, and on the left side of FIG. 5, it is shown that the second normal light emitting layer EML21b is formed wider than the second modified light emitting layer EML22b.

The portion located on the right side of FIG. 5 is the area between the side portion EML22b-1 of the second modified light emitting layer EML22b and the side portion EML21b-1 of the second normal light emitting layer EML21b, and is divided into an upper area Aus located on the upper side, a lower area Abs located on the lower side, a left area Als located on the left side, and a right area Ars located on the right side.

The portion located on the left side of FIG. 5 is the area between the corner portion EML21b-2 of the second normal light emitting layer EML21b and the recess portion EML22b-2 of the second modified light emitting layer EML22b, and is shown as the recess side area Ald.

An equal sign, shown in the center of FIG. 5, indicates that the total sum of the area shown on the left side of FIG. 5 and the area shown on the right side of FIG. 5 are equal to each other.

Therefore, since the second modified light emitting layer EML22b and the second normal light emitting layers EML11b, EML12b, and EML21b all have the same area (or size of area), and the lifespan of the light emitting layer is proportional to the planar area of the light emitting layer, all the second light emitting layers EML11b, EML12b, EML21b, and EML22b may have the same lifespan.

The area of the third light emitting layer EML11b, EML12b, EML21b, EML22b can be formed variably depending on the material constituting the light emitting layer.

Further, a difference in area between the two sides may occur due to dispersion or errors that may occur in the actual manufacturing process.

Here, the position of the edge of the light emitting layer may vary within 1 µm due to dispersion or error, and the area difference that may occur between the normal light emitting layer and the modified light emitting layer due to dispersion or error may have an area difference of up to 10%.

Although a difference in lifespan of the light emitting layer may occur due to the difference in area, this difference in lifespan may be negligible.

The recess side area Ald in FIG. 3, which is the area between the corner portion EML12c-2 of the third normal light emitting layer EML12c and the recess portion EML11c-2 of the third modified light emitting layer EML11c shown in FIG. 2, and the recess-side area Ald in FIG. 5, which is the area between the corner portion EML21b-2 of the second normal light emitting layer EML21b and the recess portion EML22b-2 of the third modified light emitting layer EML22b shown in FIG. 4, may have different sizes.

However, according to some embodiments, the recess-side areas Ald of FIG. 3 and FIG. 5 may be set equal to each other.

As shown in FIG. 2 to FIG. 5, due to the recess portion EML11c-2 of the third modified light emitting layer EML11c and the recess portion EML22b-2 of the second modified light emitting layer EML22b, a distance above a certain level can be maintained between the laser drilling position LDP and the two modified light emitting layers EML11c and EML22b, so that the light emitting layer, anode, and/or light emitting region are not damaged even when laser drilling is performed, therefore, the light emitting device is not damaged during laser drilling.

Also, when the laser drilling position LDP requires a certain area, it can be formed to span multiple adjacent unit pixels PXU11, PXU12, PXU21, PXU22 as in the embodiments of FIG. 1, so that laser drilling can be formed even in a high-resolution or high-pixel-per-inch light emitting display device.

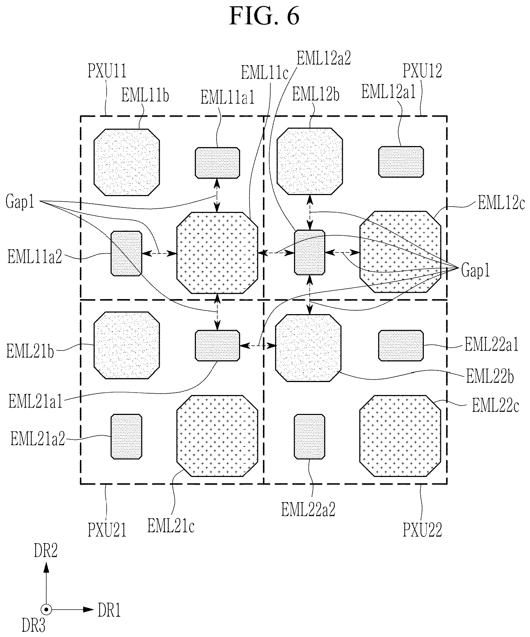

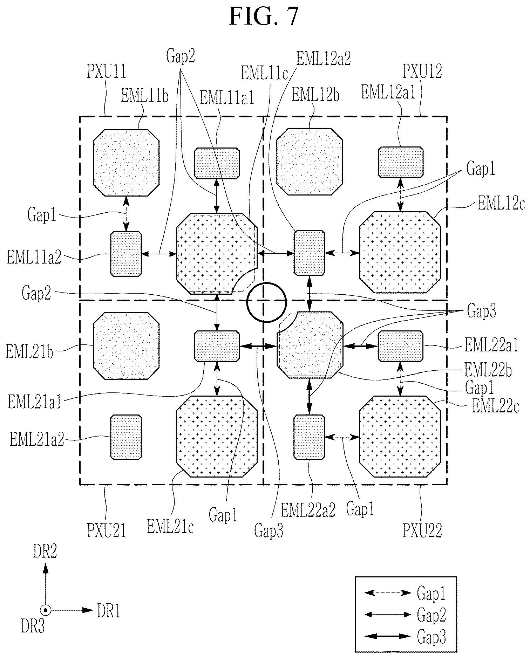

Since the spacing between adjacent light emitting layers can be changed due to the modified light emitting layer as described above, the horizontal spacing between light emitting layers will be explained in more detail through FIG. 6 and FIG. 7.

FIG. 6 is a drawing illustrating distances between light emitting layers in a comparative example, and FIG. 7 is a drawing illustrating distances between light emitting layers in the embodiments of FIG. 1.

The comparative example of FIG. 6 is an example in which laser drilling is not performed in the embodiments of FIG. 1, and the laser drilling position LDP is not included in the plurality of unit pixels PXU11, PXU12, PXU21, and PXU22.

As a result, it can be confirmed that the spacing or distance between all light emitting layers EML11a1, EML12a1, EML21a1, EML22a1, EML11a2, EML12a2, EML21a2, EML22a2, EML11b, EML12b, EML21b, EML22b, EML11c, EML12c, EML21c, EML22c is all the same and referenced as Gap1.

However, as the comparative example of FIG. 6 is modified to correspond to the embodiment of FIG. 1 including the laser drilling position LDP, the distance between the light emitting layers EML11a1, EML12a1, EML21a1, EML22a1, EML11a2, EML12a2, EML21a2, EML22a2, EML11b, EML12b, EML21b, EML22b, EML11c, EML1 2c, EML21c, and EML22c may be changed, which is shown as distances Gap1, Gap2, and Gap3 in FIG. 7.

Referring to FIG. 7, the first normal light emitting layer EML11a1, EML12a1, EML21a1, EML22a1, EML11a2, EML12a2, EML21a2, EML22a2, the second normal light emitting layer EML11b, EML12b, EML21b and the third normal light emitting layer EML12c, EML21c, EML22c can have a distance Gap1 as in FIG. 6.

However, the distance between the modified light emitting layers EML11c and EML22b, and the normal light emitting layer may have a different distance from Gap1.

For example, the third modified light emitting layer EML11c may have a distance Gap2 from adjacent normal light emitting layers EML11a1, EML11a2, EML12a2, and EML21a1, and the second modified light emitting layer EML22b may have a distance Gap3 from adjacent normal light emitting layers EML12a2, EML21a1, EML22a1, and EML22a2.

Referring to FIG. 7, the planar area of the third modified light emitting layer EML11c is larger than the planar area of the second modified light emitting layer EML22b.

The distance Gap2, which is the distance between the third modified light emitting layer EML11c having a larger area and the adjacent normal light emitting layers EML11a1, EML11a2, EML12a2, and EML21a1, is greater than the distance Gap3, which is the distance between the second modified light emitting layer EML22b, which has a smaller area, and the adjacent normal light emitting layers EML12a2, EML21a1, EML22a1, and EML22a2.

Here, distance Gap1 may have a larger value than distance Gap2 and distance Gap3, and when distance Gap1 is 100 (100 is regarded as a fictive reference to describe the relation of distances relative to each other, therefore the numbers may also be percentage values with the distance Gap1 as a reference value of 100%), distance Gap2 may be about 95, according to embodiments, for example distance Gap2 may be 92 or more and 98 or less, and distance Gap3 may be about 93, according to embodiments, for example distance Gap3 may be 90 or more and 96 or less.

However, according to some embodiments, distance Gap3 may have a larger value than distance Gap2.

In FIG. 7, the gap or distance between the recess portion (EML11c-2 in FIG. 2) of the third modified light emitting layer EML11c and the recess portion (EML22b-2 in FIG. 4) of the second modified light emitting layer EML22b located on both sides of the laser drilling position LDP (hereinafter referred to as the gap or distance between the modified light emitting layers) may have a size that is up to twice that of the distance Gap1, and when the distance Gap1 is 100, it may be 180 or more. It can have a value less than 200.

Here, the distance between the modified light emitting layers may be measured at a line passing through the center of the laser drilling position LDP, respectively may be the shortest distance between the modified light emitting layers.

Further, among the distances between the modified light-emitting layers, the length corresponding to the laser drilling position LDP-that is, the length of the diameter of the laser drilling position LDP-may be equal to the distance Gap1, and the distance between the laser drilling position LDP and one modified light emitting layer may be equal to the half of the distance Gap1.

When the distance Gap1 is 100, the diameter of the laser drilling position LDP may have a value of 90 or more and 100 or less, and the distance between the laser drilling position LDP and the modified light emitting layer may have a value of 50 or more and 55 or less.

Meanwhile, the area occupied by the laser drilling position LDP may have a value of 90 or less depending on the development of laser technology.

In the embodiments of FIG. 1 and FIG. 7, embodiments in which power is applied to the cathode through laser drilling is shown.

That is, a connecting electrode (see CE in FIG. 24) to which a voltage to be provided to the cathode is applied may be exposed through the opening, and then a cathode may be formed to apply a voltage to the cathode, which will be explained.

The opening through which the connecting electrode (see CE in FIG. 24) to which the voltage to be provided to the cathode is applied may be exposed, and may be smaller than the area of the laser drilling position LDP, and the length of the diameter of the opening may have a value smaller than the distance Gap1, and when the distance Gap1 is 100, it may have a value of 30 or more and less than 100.

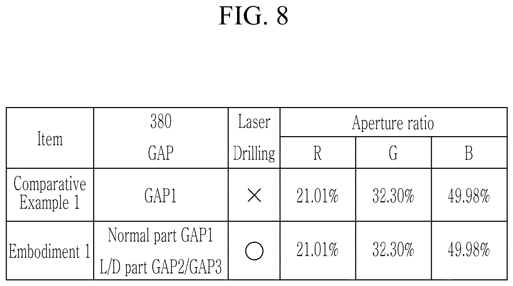

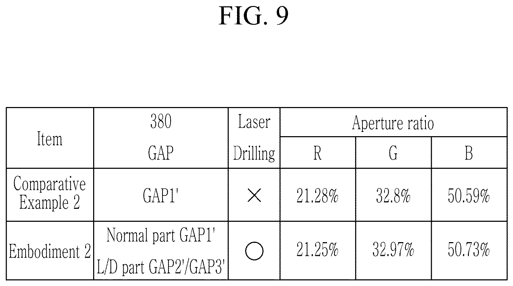

Hereinafter, the characteristics of comparative examples and embodiments will be numerically reviewed through FIG. 8 and FIG. 9.

FIG. 8 and FIG. 9 are tables showing characteristics of each comparative example and some embodiments.

FIG. 8 and FIG. 9 show values measured based on light emitting display devices having different pixel per inch (ppi) values. FIG. 8 is the same light emitting display device as in FIG. 1 and FIG. 7, and FIG. 9 is a light emitting display device different from those of FIG. 1 and FIG. 7.

Here, FIG. 8 may be a 218 ppi light emitting display device, and FIG. 9 may be a 254 ppi light emitting display device.

First, comparative example 1 and embodiment 1 will be compared and reviewed through FIG. 8.

Comparative example 1 is shown in FIG. 6, and embodiment 1 may be the same as FIG. 1 and FIG. 7.

Also, in FIG. 8 and FIG. 9, R corresponds to the light emitting layer for red, corresponding to the first light emitting layer of FIG. 1, FIG. 6, and FIG. 7, G corresponds to the light emitting layer for green, corresponding to the second light emitting layer of FIG. 1, FIG. 6, and FIG. 7, and B corresponds to the light emitting layer for blue, corresponding to the third light emitting layer of FIG. 1, FIG. 6, and FIG. 7.

Referring to FIG. 8, in comparative example 1, laser drilling is not performed, and in embodiment 1, laser drilling is performed.

FIG. 8 shows that the aperture ratio of each color in comparative example 1 and the aperture ratio of each color in embodiment 1 are the same, and at this time, the distance or gap (380 GAP) of the pixel defining layer (see 380 in FIG. 10) - that is, the distance or gap between the light emitting layers - is indicated.

Gap1 is a distance between normal light emitting layers in FIG. 6, and may be the same as the distance (normal direction) between normal light emitting layers in embodiment 1.

However, in embodiment 1, the laser drilling part (L/D part) may have a value of distance Gap2 or Gap3, and the distance positions Gap2 and Gap3 may be as shown in FIG. 7.

Here, the distance Gap1 may be about 25 µm, the distance Gap2 may be about 24 µm, and the distance Gap3 may be about 23.5 µm.

On the other hand, comparative example 2 and embodiment 2 through FIG. 9 show as follows.

Comparative example 2 is similar to FIG. 6, but the size of the actual distance Gap1 may differ from comparative example 1 due to the different ppi value, and in the case of embodiment 2, it is similar to FIG. 7, but the sizes of the actual distances Gap1, Gap2, and Gap3 may differ due to the different ppi value.

Referring to FIG. 9, it is shown that laser drilling is not performed in comparative example 2, and laser drilling is performed in embodiment 2, and additionally, the aperture ratio of each color in comparative example 2 and the aperture ratio of each color in embodiment 2 are not completely the same, but it can be seen that they are formed almost the same.

Meanwhile, the distance or gap (380 GAP) of the pixel defining layer (see 380 in FIG. 10) in comparative example 2 and embodiment 2 - that is, the distance between the light emitting layers - may be as follows.

Gap1' is the distance between the normal light emitting layers in comparative example 2, and may be the same as the distance (normal direction) between the normal light emitting layers in embodiment 2.

However, in embodiment 2, the laser drilling position (L/D portion) may have a value of distance Gap2' or Gap3'.

The distance positions of Gap2' and Gap3' may be the same as the distance positions of Gap2 and Gap3 in FIG. 7, respectively.

Here, distance Gap1' may be about 21.5 µm, distance Gap2' may be about 20 µm, and distance Gap3' may be about 19.8 µm.

Referring to FIG. 8 and FIG. 9, the distances between the normal light emitting layers (Gap1, Gap1') may have larger values than the distances between the modified light emitting layers (Gap2, Gap3, Gap2', and Gap3'), and they can have the following values.

The distances as described above may be changed according to embodiments.

Hereinafter, a cross-sectional structure of a light emitting display device according to some embodiments will be schematically reviewed through FIG. 10.

FIG. 10 is a cross-sectional view of a light emitting display device according to some embodiments.

In the cross-sectional view of FIG. 10, a layer corresponding to a cathode, a pixel defining layer 380, an intermediate layer including a functional layer FL and a light emitting layer, and an anode is also referred to as a light emitting device layer, and a planarization layer may be located below the light emitting device layer - that is, below the anode - and a conductive layer constituting a transistor and a capacitor, a semiconductor layer, and an insulating layer located thereunder may also be referred to as a driving element layer. The interlayer insulating layer 161 may be used as a planarization layer.

FIG. 10 shows one light emitting device, and an opening OP positioned in the pixel defining layer 380 to expose a portion of the anode and an opening OP2 through which current is transferred from one transistor of the pixel driving unit (refer to PCa, PCb, and PCc in FIG. 24) to the anode are also shown.

In addition, in FIG. 10, a position LDP where laser drilling is performed is also schematically shown.

In FIG. 10, the structure under the anode - that is, the structure of the driving device layer - is simply depicted with only one transistor shown.

A brief overview of the driving element layer structure from the substrate 110 to the interlayer insulating layer 161 is as follows.

The substrate 110 may include a rigid material, such as glass, that does not bend, or may include a flexible material that can bend, such as plastic or polyimide.

In the case of a flexible substrate, a double-layered structure of polyimide and a barrier layer formed of an inorganic insulating material thereon may be repeatedly formed.

A lower shielding layer BML including metal is positioned on the substrate 110, and the lower shielding layer BML may overlap a channel of one of the transistors positioned in the pixel driving units (PCa, PCb, PCc) included in the pixel on a plane.

According to some embodiments, a driving low-voltage line (see 174 of FIG. 24) to which the driving low-voltage ELVSS is applied may be positioned on the same layer as the lower shielding layer BML.

The substrate 110 and the lower shielding layer BML are covered by the buffer layer 111.

The buffer layer 111 serves to block penetration of impurity elements into the semiconductor layer ACT, and may be an inorganic insulating layer including silicon oxide SiOₓ, silicon nitride SiNₓ, or silicon oxynitride SiONₓ.

A semiconductor layer ACT formed of a silicon semiconductor (e.g., polycrystalline semiconductor (P-Si)) or an oxide semiconductor is positioned on the buffer layer 111.

The semiconductor layer ACT is a semiconductor layer positioned in the pixel driving units PCa, PCb, and PCc included in the pixel, and may include a channel of a transistor including a driving transistor and a first region and a second region positioned on both sides thereof.

Here, the channel of the transistor may be a portion of the semiconductor layer ACT overlapping the gate electrode GE, and the first region and the second region may be portions of the semiconductor layer ACT that do not overlap the gate electrode GE.

That is, the first region and the second region positioned on both sides of the channel of the semiconductor layer ACT are not covered by the gate electrode GE, and have conductive layer characteristics by plasma treatment or doping, so that they can serve as the first and second electrodes of the transistor.

A first gate insulating layer 141 may be positioned on the semiconductor layer ACT.

The first gate insulating layer 141 may be an inorganic insulating layer including silicon oxide SiOₓ, silicon nitride SiNₓ, or silicon oxynitride SiONₓ.

A first gate conductive layer including the gate electrodes GE of transistors positioned in the pixel driving units PCa, PCb, and PCc may be positioned on the first gate insulating layer 141.

An auxiliary driving low-voltage line 174-1 is positioned in the first gate conductive layer, and scan lines may be formed in addition to gate electrodes GE of transistors positioned in the pixel driving units PCa, PCb, and PCc.

Meanwhile, the first gate conductive layer may include one electrode of one capacitor positioned in the pixel driving units PCa, PCb, and PCc.

The first gate conductive layer may include a metal or metal alloy such as aluminum (Al), copper (Cu), molybdenum (Mo), titanium (Ti), or the like, and may be composed of a single layer or multiple layers.

After forming the first gate conductive layer, a plasma treatment or a doping process may be performed to make an exposed region of the first semiconductor layer a conductor.

That is, the semiconductor layer ACT covered by the gate electrode GE is not conductive, and a portion of the semiconductor layer ACT not covered by the gate electrode GE may have the same characteristics as the conductive layer.

An interlayer insulating layer 161 may be positioned on the first gate conductive layer and the first gate insulating layer 141.

The interlayer insulating layer 161 may include an inorganic insulating layer including silicon oxide SiOₓ, silicon nitride SiNₓ, silicon oxynitride SiONₓ, or the like, and according to some embodiments, an inorganic insulating material may be formed thickly.

Also, according to some embodiments, the interlayer insulating layer 161 may be formed of an organic insulating layer and may include one or more materials selected from the group consisting of polyimide, polyamide, acrylic resin, benzocyclobutene, and phenol resin.

An anode layer including an anode and a connecting electrode CE is positioned on the interlayer insulating layer 161.

The anode is connected to the second region of the semiconductor layer ACT serving as the second electrode of the transistor through an opening (OP2; hereinafter referred to as an anode opening) located in the interlayer insulating layer 161 and the first gate insulating layer 141.

As a result, the anode can receive the output of the transistor.

The connecting electrode CE is formed of the same material as the anode and is connected to the auxiliary driving low-voltage line 174-1 through an opening (OP1; hereinafter referred to as a laser drilling opening) located in the interlayer insulating layer 161.

As a result, the connecting electrode CE receives the driving low-voltage ELVSS. The anode layer may be composed of a single layer including a transparent conductive oxide layer or a metal material, or a multi-layer including the same.

The transparent conductive oxide layer may include indium tin oxide (ITO), poly-ITO, indium zinc oxide (IZO), indium gallium zinc oxide (IGZO), and indium tin zinc oxide (ITZO).

The metal material may include silver (Ag), molybdenum (Mo), copper (Cu), gold (Au), and aluminum (Al).

A pixel defining layer 380 including an opening OP is formed on the anode layer.

An opening (OP; hereinafter, also referred to as a light emitting device opening) of the pixel defining layer 380 is a portion corresponding to the light emitting region and/or the light emitting layer EML, exposes a portion of the anode, and may have a tapered sidewall.

The light emitting layer EML is positioned within the opening OP of the pixel defining layer 380, and the light emitting layer EML may also be positioned on the pixel defining layer 380 as shown in FIG. 10 according to some embodiments.

The light emitting layer EML may be formed by an inkjet method, and may include at least one of quantum dot materials according to some embodiments.

When the light emitting layer EML is formed by the inkjet method, the pixel defining layer 380 may serve to partition the injected liquid, and in this case, the light emitting layer EML may be positioned only within the opening OP of the pixel defining layer 380.

The light emitting layer (EML) may include a quantum dot material, and according to some embodiments, a color conversion layer including a quantum dot material may be separately positioned above the cathode.

In the present specification, a quantum dot means a crystal of a semiconductor compound, and may include any material capable of emitting light of various emission wavelengths according to the size of the crystal or by adjusting the ratio of elements in the quantum dot compound.

The diameter of the quantum dots may be, for example, about 1 nm to 10 nm.

Quantum dots may be synthesized by a wet chemical process, an organometallic chemical vapor deposition process, a molecular beam epitaxy process, or a process similar thereto.

The wet chemical process is a method of growing quantum dot particle crystals after mixing an organic solvent and a precursor material.

When the crystal grows, since the organic solvent acts as a dispersant naturally coordinated on the surface of the quantum dot crystal and controls the growth of the crystal, the growth of quantum dot particles can be controlled through a process that is easier and cheaper than vapor deposition methods such as metal organic chemical vapor deposition MOCVD or molecular beam epitaxy MBE.

Quantum dots are group III-VI semiconductor compounds; group II-VI semiconductor compounds; group III-V semiconductor compounds; group I-III-VI semiconductor compounds; group IV-VI semiconductor compounds; group IV elements or compounds; or any combination thereof.

Examples of II-VI group semiconductor compounds include binary element compounds such as CdS, CdSe, CdTe, ZnS, ZnSe, ZnTe, ZnO, HgS, HgSe, HgTe, MgSe, MgS and the like; ternary compounds such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and the like; quaternary compounds such as CdZnSeS, CdZnSeTe, CdZnSTe, CdHgSeS, CdHgSeTe, CdHgSTe, HgZnSeS, HgZnSeTe, HgZnSTe, and the like; or any combination thereof.

Examples of group III-V semiconductor compounds include binary element compounds such as GaN, GaP, GaAs, GaSb, AIN, AlP, AlAs, AlSb, InN, InP, InAs, InSb, and the like; ternary compounds such as GaNP, GaNAs, GaNSb, GaPAs, GaPSb, AINP, AlNAs, AlNSb, AlPAs, AlPSb, InGaP, InNP, InAlP, InNAs, InNSb, InPAs, InPSb, GaAlNP, and the like; quaternary compounds such as GaAINAs, GaAINSb, GaAlPAs, GaAlPSb, GaInNP, GaInNAs, GaInNSb, GaInPAs, GaInPSb, InAlNP, InAINAs, InAlNSb, InAlPAs, InAlPSb, and the like; or any combination thereof.

Meanwhile, the group III-V semiconductor compound may further include a group II element.

Examples of the group III-V semiconductor compound further including a group II element may include InZnP, InGaZnP, InAlZnP, and the like.

Examples of group III-VI semiconductor compounds include binary element compounds such as GaS, Ga2S3, GaSe, Ga2Se3, GaTe, InS, InSe, In2Se3, InTe, and the like; ternary compounds such as InGaS3 and InGaSe3; or any combination thereof.

Examples of the group I-III-VI semiconductor compound include ternary compounds such as AgInS, AgInS2, AgInSe2, AgGaS, AgGaS2, AgGaSe2, CuInS, CuInS2, CuInSe2, CuGaS2, CuGaSe2, CuGaO2, AgGaO2, AgAlO2, and the like; quaternary compounds such as AgInGaS2 and AgInGaSe2; or any combination thereof.

Examples of group IV-VI semiconductor compounds include binary element compounds such as SnS, SnSe, SnTe, PbS, PbSe, PbTe, and the like; ternary compounds such as SnSeS, SnSeTe, SnSTe, PbSeS, PbSeTe, PbSTe, SnPbS, SnPbSe, SnPbTe, and the like; quaternary compounds such as SnPbSSe, SnPbSeTe, and SnPbSTe; or any combination thereof.

Group IV elements or compounds include single-element compounds such as Si, Ge, and the like; binary element compounds such as SiC, SiGe, and the like; or any combination thereof.

Each element included in a multi-element compound such as a binary element compound, a ternary element compound, and a quaternary element compound may be present in a particle at a uniform concentration or a non-uniform concentration.

That is, the chemical formula means the types of elements included in the compound, and the element ratios in the compound may be different.

For example, AgInGaS₂ may mean AgInₓGa₁-ₓS₂ (ₓ is a real number between 0 and 1).

On the other hand, the quantum dot may have a single structure in which the concentration of each element included in the quantum dot is uniform or a dual core-shell structure.

For example, a material included in the core and a material included in the shell may be different from each other.

The shell of the quantum dots may serve as a protective layer for maintaining semiconductor properties by preventing chemical denaturation of the core and/or as a charging layer for imparting electrophoretic properties to the quantum dots.

The shell may be monolayer or multilayer.

The interface between the core and the shell may have a concentration gradient in which the concentration of elements present in the shell decreases toward the center.

Examples of the quantum dot shell include oxides of metals or non-metals, semiconductor compounds, or combinations thereof.

Examples of oxides of metals or nonmetals include binary element compounds such as SiO₂, Al₂O₃, TiO₂, ZnO, MnO, Mn₂O₃, Mn₃O₄, CuO, FeO, Fe₂O₃, Fe₃O₄, CoO, Co₂O₄, NiO, and the like; ternary compounds such as MgAl₂O₄, CoFe₂O₄, NiFe₂O₄, CoMn₂O₄ and the like; or any combination thereof.

Examples of semiconductor compounds include group III-VI semiconductor compounds, as described herein; group II-VI semiconductor compounds; group III-V semiconductor compounds; group I-III-VI semiconductor compounds; group IV-VI semiconductor compounds; or any combination thereof.

For example, the semiconductor compound may include CdS, CdSe, CdTe, ZnS, ZnSe, ZnTe, ZnSeS, ZnTeS, GaAs, GaP, GaS, GaSe, AgGaS, AgGaS2, GaSb, HgS, HgSe, HgTe, InAs, InP, InGaP, InSb, AlAs, AlP, AlSb, or any combination thereof.

Each element included in a multi-element compound such as a two-element compound or a three-element compound may be present in a particle at a uniform or non-uniform concentration.

That is, the chemical formula means the types of elements included in the compound, and the element ratios in the compound may be different.

Quantum dots may have a full width of half maximum (FWHM) of an emission wavelength spectrum of about 45 nm or less, specifically about 40 nm or less, more specifically about 30 nm or less, and color purity or color reproducibility can be improved within this range.

In addition, since light emitted through the quantum dots is emitted in all directions, a wide viewing angle may be improved.

In addition, the shape of the quantum dots may be in the form of spherical, pyramidal, multi-arm, or cubic nanoparticles, nanotubes, nanowires, nanofibers, nanoplatelet particles, and the like.

Since the energy band gap can be controlled by adjusting the size of the quantum dots or the ratio of elements in the quantum dot compound, light of various wavelengths can be obtained from the quantum dot light emitting layer.

Therefore, by using quantum dots as described above (using quantum dots of different sizes or having different element ratios in a quantum dot compound), a light emitting device emitting light of various wavelengths can be implemented.

For example, control of the size of the quantum dots or the ratio of elements in the quantum dot compound may be selected to emit red, green and/or blue light.

In addition, the quantum dots may be configured to emit white light by combining light of various colors.

A first functional layer FL1 may be positioned between the anode and the light emitting layer EML, and a second functional layer FL2 may be positioned on the light emitting layer EML.

Here, the first functional layer FL1 may include a hole injection layer and/or a hole transport layer, and the second functional layer FL2 may include an electron transport layer and/or an electron injection layer.

Here, the functional layer FL and the light emitting layer EML may be referred to as an intermediate layer.

The first functional layer FL1 and the second functional layer FL2 are also formed on the pixel defining layer 380 and in the opening OP.

Therefore, in the embodiments of FIG. 10, all of the intermediate layers are located above the pixel defining layer 380 and within the opening OP.

However, according to some embodiments, the light emitting layer EML is positioned only within the opening OP of the pixel defining layer 380, and the functional layer FL may be formed on the pixel defining layer 380 and also within the opening OP.

A cathode is formed on the second functional layer FL2 and on the pixel defining layer 380 and the opening OP.

The anode, the light emitting layer EML, and the cathode constitute a light emitting device, and the light emitting device may further include a functional layer FL.

The current delivered to the anode passes through the first functional layer FL1, the light emitting layer EML, and the second functional layer FL2 and is delivered to the cathode.

At this time, the light emitting layer EML emits light due to the current flowing through the light emitting layer EML, so that the first light emitting device exhibits luminance.

Referring to FIG. 10, the cathode is connected to the connecting electrode CE at the laser drilling position LDP where laser drilling is performed, and receives the driving low-voltage ELVSS from the auxiliary driving low-voltage line 174-1 through the connecting electrode CE.

FIG. 10 shows a cross-sectional structure of the laser drilling position LDP where laser drilling is performed, and the cathode, the functional layer FL, the light emitting layer EML, and the pixel defining layer 380 are cleanly connected to the lower connecting electrode CE with an opening.

However, since the intermediate layer and the pixel defining layer 380 are melted by the laser, and the cathode and the connecting electrode CE are electrically connected, the cross-sectional structure may not be neat, unlike FIG. 10.

Meanwhile, according to some embodiments, a spacer may be further formed on the pixel defining layer 380, and the spacer may have a tapered sidewall like the pixel defining layer 380.

Although the structure on the cathode is not shown in FIG. 10, an encapsulation layer may be positioned according to some embodiments.

The encapsulation layer may include at least one inorganic layer and at least one organic layer, and may have a triple-layer structure including a first inorganic encapsulation layer, an organic encapsulation layer, and a second inorganic encapsulation layer.

The encapsulation layer may be for protecting the light emitting layer EML from moisture or oxygen that may be introduced from the outside.

According to some embodiments, the encapsulation layer may include a structure in which an inorganic layer and an organic layer are sequentially stacked.

According to some embodiments, a sensing insulation layer and a plurality of sensing electrodes may be positioned on the encapsulation layer for touch sensing.

According to some embodiments, a layer including a polarizing plate may be attached to the encapsulation layer to reduce reflection of external light.

In addition, a color filter or a color conversion layer may be further formed to improve color quality, and at this time, a polarizing plate may not be attached.

A light blocking layer may be positioned between the color filters or the color conversion layer.

In addition, according to some embodiments, a layer having a material capable of absorbing some wavelengths of external light (hereinafter referred to as a reflection adjusting material) may be further included, and in this case, a polarizing plate may not be attached.

In addition, according to some embodiments, the front surface of the light emitting display device may be flattened by covering it with an additional organic layer (also referred to as a planarization layer).

FIG. 10 is a cross-sectional structure according to some embodiments, and various modified structures may be possible.

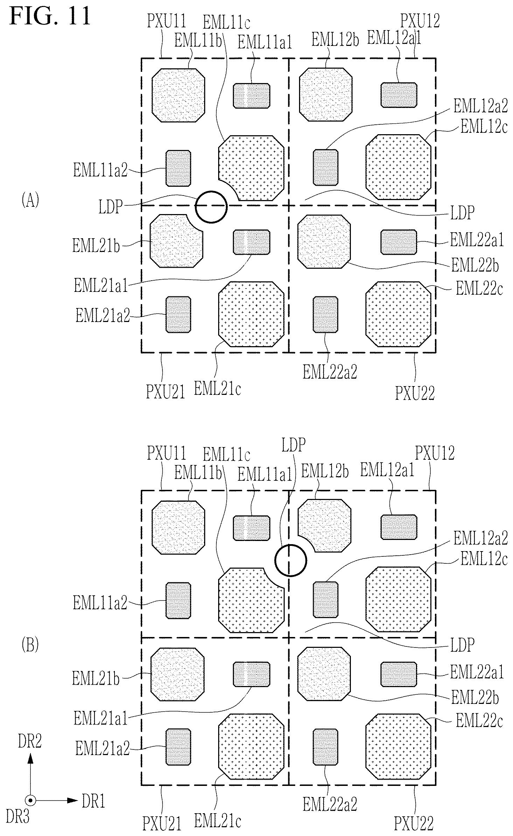

Hereinafter, modified embodiments of the above embodiments will be reviewed through FIG. 11 to FIG. 23.

FIG. 11 to FIG. 23 are drawings showing each modified embodiment in more detail.

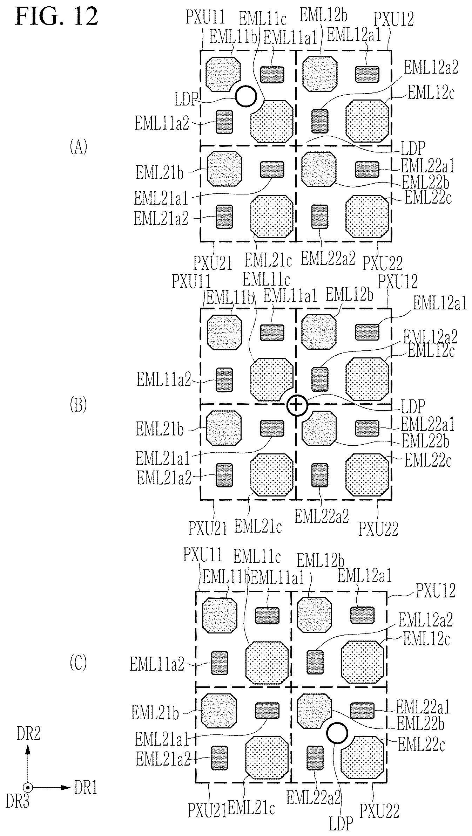

First, in FIG. 11 and FIG. 12, embodiments in which the laser drilling position LDP in the light emitting display device is modified differently from those of FIG. 1 or FIG. 7 will be described.

In FIG. 11, two embodiments in which laser drilling positions LDP are arranged across two unit pixels among four adjacent unit pixels PXU11, PXU12, PXU21, and PXU22 are shown.

In FIG. 11(A), the laser drilling position LDP is formed over two unit pixels PXU11 and PXU21, the two light emitting layers EML11c and EML21b adjacent to the laser drilling position LDP are formed as modified light emitting layers including recesses, and the remaining light emitting layers (EML11a1, EML12a1, EML21a1, EML22a1, EML11a2, and EML12 a2, EML21a2, EML22a2, EML11b, EML12b, EML22b, EML12c, EML21c, EML22c) are formed as normal light emitting layers.

Here, the recess is formed on the laser drilling position LDP side of the modified light emitting layers (EML11c, EML21b).

Meanwhile, in FIG. 11(B), the laser drilling position LDP is formed over two unit pixels PXU11 and PXU12, the two light emitting layers EML11c and EML12b adjacent to the laser drilling position LDP are formed as modified light emitting layers including recesses, and the remaining light emitting layers (EML11a1, EML12a1, EML21a1, EML22a1, EML11a2, EML 12a2, EML21a2, EML22a2, EML11b, EML21b, EML22b, EML12c, EML21c, EML22c) are formed as normal light emitting layers.

Here, the recess is formed on the laser drilling position LDP side of the modified light emitting layers EML11c and EML12b.

In one light emitting display device, the laser drilling position LDP may be formed only at the position shown in FIG. 11(A) or only at the position shown in FIG. 11(B).

However, according to some embodiments, the laser drilling positions LDP formed at positions shown in FIG. 11(A) and FIG. 11(B) in one light emitting display device may be alternately arranged.

On the other hand, according to some embodiments, three positions including not only positions shown in FIG. 11(A) and FIG. 11(B) but also laser drilling positions LDP formed at positions shown in FIG. 1 may be alternately arranged in one light emitting display device.

As described above, when the laser drilling positions LDP are variously arranged, the display quality may be uniform over the entire area of the light emitting display device.

In particular, even when the user rotates the light emitting display device by 90 degrees, the laser drilling position LDP is not skewed to one side, so the display quality can be constant.

Meanwhile, in FIG. 12, two examples in which the laser drilling position LDP is located within one unit pixel among four adjacent unit pixels PXU11, PXU12, PXU21, and PXU22 are shown.

In FIG. 12(A), the laser drilling position LDP is formed within the unit pixel PXU11, the two light emitting layers (EML11c and EML11b) adjacent to the laser drilling position LDP are formed as modified light emitting layers including recesses, and the remaining light emitting layers (EML11a1, EML12a1, EML21a1, EML22a1, EML11a2, EML12a2, EML21a) 2, EML22a2, EML12b, EML21b, EML22b, EML12c, EML21c, EML22c) are formed as normal light emitting layers.

Here, the recess is formed on the laser drilling position LDP side of the modified light emitting layers (EML11c, EML11b).

Meanwhile, in FIG. 12(C), the laser drilling position LDP is formed in the unit pixel PXU22, the two light emitting layers (EML22c and EML22b) adjacent to the laser drilling position LDP are formed as modified light emitting layers including recesses, and the remaining light emitting layers (EML11a1, EML12a1, EML21a1, EML22a1, EML11a2, EML12a2, EML21 a2, EML22a2, EML11b, EML12b, EML21b, EML11c, EML12c, EML21c) are formed as normal light emitting layers.

Here, the recess is formed on the laser drilling position LDP side of the modified light emitting layers (EML22c, EML22b).

In FIG. 12, FIG. 12(B) is additionally shown, and in FIG. 12(B), a laser drilling position LDP is formed at the same position as FIG. 1.

In one light emitting display device, the laser drilling position LDP may be formed only at the position shown in FIG. 12(A) or only at the position shown in FIG. 12(C).

However, according to some embodiments, three laser drilling positions LDP each formed at positions shown in FIG. 12(A) to FIG. 12(C) may be alternately arranged in one light emitting display device.

As described above, when the laser drilling positions LDP are variously arranged, display quality may be uniform over the entire area of the light emitting display device.

In particular, even when the user rotates the light emitting display device by 90 degrees, the laser drilling position LDP is not skewed to one side, so the display quality can be constant.

Referring to FIG. 11 and FIG. 12, laser drilling positions LDP may be different from each other in at least two different unit pixel groups included in the light emitting display device.

Hereinafter, referring to embodiments in which the modified light emitting layer is modified in a manner different from that of FIG. 2 to FIG. 5 through FIG. 13 and FIG. 14, FIG. 13 is a view in which the light emitting layer EML11c of FIG. 2 is additionally transformed based on the unit pixel PXU11.

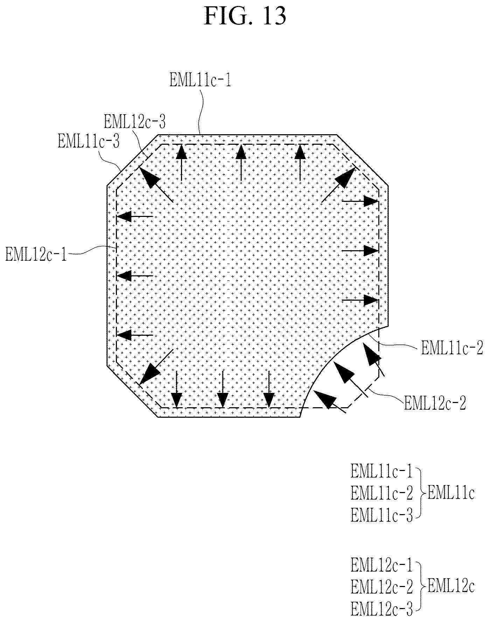

For example, the third modified light emitting layer EML11c in FIG. 13 extends even at the corner portion EML 11-c3 beyond a corresponding third normal light emitting layer, unlike the embodiments of FIG. 2.

In FIG. 13, the third normal light emitting layer EML12c is indicated by a dotted line, and the third normal light emitting layer EML12c not only has a side portion EML12c-1 and a corner portion EML12c-2 corresponding to the recess portion EML11c-2 of the third modified light emitting layer EML11c, but additionally includes a corner portion EML12c-3.

Meanwhile, the third modified light emitting layer EML11c is illustrated by a solid line, and the third modified light emitting layer EML11c not only has the side portion EML11c-1 and the recess portion EML11c-2, but also includes corner portions EML11-c3.

An arrow, shown in FIG. 13, shows a direction in which deformation occurs in the third normal light emitting layer EML12c and is changed to the third modified light emitting layer EML11c.

That is, it extends from the side portion EML12c-1 of the third normal light emitting layer EML12c to the side portion EML11c-1 of the third modified light emitting layer EML11c, and extends from the corner portion EML12c-3 of the third normal light emitting layer EML12c to the corner portion EML11-c3 of the third modified light emitting layer EML11c, and the third normal light emitting layer EML12c is reduced from the corner portion EML12c-2 to the recess portion EML11c-2 of the third modified light emitting layer EML11c.

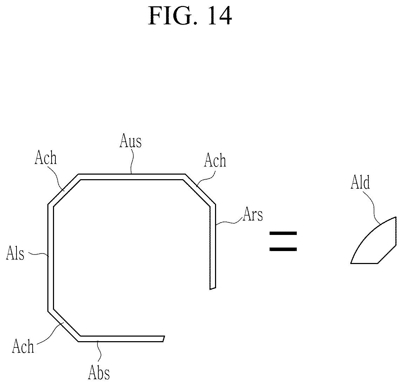

Meanwhile, in FIG. 14, the relationship between areas of the third normal light emitting layer EML12c and the third modified light emitting layer EML11c is different.

In FIG. 14, only the portion where the third modified light emitting layer EML11c is formed wider than the third normal light emitting layer EML12c is shown on the left side, and on the right side of FIG. 14 is the area between the corner portion EML12c-2 of the third normal light emitting layer EML12c and the recess portion EML11c-2 of the third modified light emitting layer EML11c, and is shown as the recess side area Ald.

The area located on the left side of FIG. 14 is the area between the edge portion EML11c-1 and corner portion EML11-c3 of the third modified light emitting layer EML11c, and the edge portion EML12c-1 and the corner portion EML12c-3 of the third normal light emitting layer EML12c, it consists of the upper area (Aus) located at the top, the lower area (Abs) located at the bottom, the left area (Als) located on the left, the right area (Ars) located on the right, and the three corner areas (Ach) connecting them, and they are all interconnected.

A portion located on the right side of FIG. 14 is the area between the corner portion EML12c-2 of the third normal light emitting layer EML12c and the recess portion EML11c-2 of the third modified light emitting layer EML11c, and is shown as the recess side area Ald.

An equal sign, shown in the center of FIG. 14, indicates that the total sum of areas shown on the left side of FIG. 14 and the area shown on the right side of FIG. 14 are equal to each other.

Therefore, since the third modified light emitting layer EML11c and the third normal light emitting layers EML12c, EML21c, and EML22c all have the same area (or size of area), the lifespan of the light emitting layer is proportional to the planar area of the light emitting layer, and all the third light emitting layers EML11c, EML12c, EML21c, and EML22c may have the same lifespan.

The area of the third light emitting layers EML11c, EML12c, EML21c, and EML22c may be formed in various ways according to the material constituting the light emitting layer.

Meanwhile, a difference in area between the two sides may occur due to dispersion or errors that may occur in the actual manufacturing process.

Here, the position of the edge of the light emitting layer may vary within 1 µm due to dispersion or error, and the area difference that may occur between the normal light emitting layer and the modified light emitting layer due to dispersion or error may have an area difference of up to 10%.

Although a difference in lifespan of the light emitting layer may occur due to the difference in area, this difference in lifespan may be negligible.

When the recess side area Ald is the same in the embodiments of FIG. 13 and FIG. 14 and the embodiments of FIG. 2 and FIG. 3, the upper area Aus located on the upper side, the lower area Abs located on the lower side, the left area Als located on the left side, and the right area Ars located on the right side of the embodiments of FIG. 13 and FIG. 14 may have an area smaller than the upper area Aus, the lower area Abs located on the lower side, the left area Als located on the left side, and the right area Ars located on the right side of FIG. 2 and FIG. 3.

The amendment shown in FIG. 13 and FIG. 14 and explained on basis of FIG. 2 and FIG. 3 can also be provided with the embodiment shown in FIG. 4 and FIG. 5, such that the embodiments of FIG. 4 and FIG. 5 can also have an expanded corner area (Ach) like that in FIG. 13 and FIG. 14.

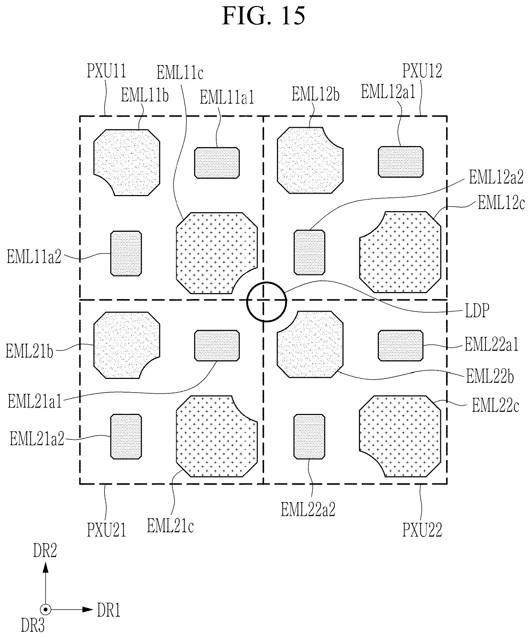

FIG. 15 shows embodiments in which the second light emitting layers EML11b, EML12b, EML21b, and EML22b and the third light emitting layers EML11c, EML12c, EML21c, and EML22c are formed as modified light emitting layers having identical recesses, respectively.

In the embodiments of FIG. 15, the positions of the recesses of the second light emitting layers EML11b, EML12b, EML21b, and EML22b are arranged differently, and the positions of the recesses of the third light emitting layers EML11c, EML12c, EML21c, and EML22c are also arranged differently. That is, the orientations of the recesses of the second light emitting layers EML11b, EML12b, EML21b, and/or EML22b may be different to each other, and the orientations of the recesses of the third light emitting layers EML11c, EML12c, EML21c, and EML22c may be different to each other.

Here, the positions of the recesses of the two light emitting layers EML11c and EML22b adjacent to the laser drilling position LDP are fixed to be located on the side of the laser drilling position LDP, and the positions of the recesses of the other light emitting layers are free.

That is, the recesses of the second modified light emitting layers EML11b, EML12b, and EML21b and the third modified light emitting layers EML12c, EML21c, and EML22c located away from the laser drilling position LDP may be positioned on a side different from the side on which the recesses are located in the second and third modified light emitting layers EML22b and EML11c adjacent to the laser drilling position LDP, respectively.

Referring to FIG. 15, in a unit pixel group composed of four unit pixels PXU11, PXU12, PXU21, PXU22, the second modified light emitting layer EML11b, EML12b, EML21b, EML22b and the third modified light emitting layer EML11c, EML12c, EML21c, EML22c have a rectangular shape like a normal light emitting layer, except for the recess, and can have corners that are cut off or rounded. Each of the second modified light emitting layers EML11b, EML12b, EML21b, EML22b and the third modified light emitting layers EML11c, EML12c, EML21c, EML22c are included four times in a unit pixel group, the second modified light emitting layers EML11b, EML12b, EML21b and the third modified light emitting layers EML12c, EML21c, EML22c located away from the laser drilling position LDP are each three, and the second modified light-emitting layer EML22b and the third modified light emitting layer EML11c located adjacent to the laser drilling position LDP are each one, corners at which recesses are located in the second modified light emitting layer EML22b and third modified light emitting layer EML11c adjacent to the laser drilling position LDP may be different from corners at which recesses are located in the second modified light emitting layers EML11b, EML12b, and EML21b and third modified light emitting layers EML12c, EML21c, and EML22c away from the laser drilling position LDP.

According to the embodiments of FIG. 15, the user cannot easily recognize the position of the recess of the modified light emitting layer, and in particular, it is difficult for the user to visually recognize the position of the recess of the transformable light emitting layer even when the user rotates the light emitting display device by 90 degrees, thus, the display quality can be constant.

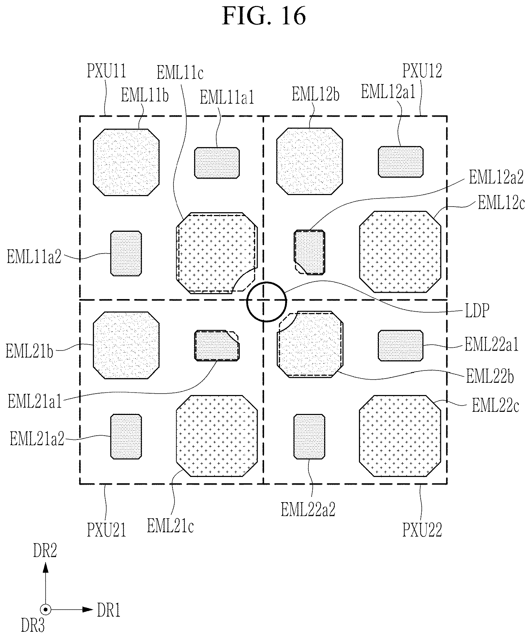

Meanwhile, in FIG. 16, unlike the embodiments of FIG. 1, the first light emitting layers EML12a2 and EML21a1 positioned adjacent to the laser drilling position LDP are also formed as modified light emitting layers.

In FIG. 16, an additional description of the two modified light emitting layers EML11c and EML22b having the same structure as that of FIG. 1 is omitted.

Referring to FIG. 16, among the first light emitting layers EML11a1, EML12a1, EML21a1, EML22a1, EML11a2, EML12a2, EML21a2, and EML22a2, the two first light emitting layers EML12a2 and EML21a1 positioned adjacent to the laser drilling position LDP are formed as modified light emitting layers having recesses.

For example, in FIG. 16, the first modified light emitting layer EML12a2 positioned in the unit pixel PXU12 and the first modified light emitting layer EML21a1 positioned in the unit pixel PXU21 are shown as solid lines, and a dotted line overlapping them is also shown.

Here, the dotted lines indicate the sizes of the first normal light emitting layers (EML11a1, EML12a1, EML22a1, EML11a2, EML21a2, EML22a2) located in different parts, and are explained through FIG. 2 to FIG. 5 in detail.

The first modified light emitting layers EML12a2 and EML21a1 according to the embodiments of FIG. 16 differ only in the direction in which they extend, and may have the same overall shape.

Hereinafter, a planar shape of the first modified light emitting layer EML21a1 positioned in the unit pixel PXU21 among the first modified light emitting layers EML12a2 and EML21a1 will be described in detail.

The boundary of the first modified light emitting layer EML21a1 shown as a solid line is located outside the dotted line except for the recess.

As a result, it can be confirmed that the first modified light emitting layer EML21a1 extends more than the first normal light emitting layers EML11a1, EML12a1, and EML22a1 in each direction except for the recess.

However, the first normal light emitting layers EML11a1, EML12a1, and EML22a1 are formed to be larger in the portion where the recess of the first modified light emitting layer EML21a1 is located.

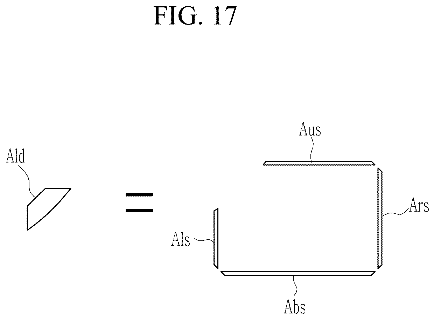

Also, as shown in FIG. 17, the first modified light emitting layer EML21a1 and the first normal light emitting layers EML11a1, EML12a1, and EML22a1 may all have the same size of their area.

For example, on the right side of FIG. 17, it is shown that the first modified light emitting layer EML21a1 is formed wider than the first normal light emitting layer EML11a1, EML12a1, EML22a1, and on the left side of FIG. 17, it is shown that the first normal light emitting layer EML11a1, EML12a1, EML22a1 is formed wider than the first modified light emitting layer EML21a1.

In FIG. 17, the portion located on the right side is the area between the side portion of the first modified light emitting layer EML21a1 and the side portion of the first normal light emitting layers EML11a1, EML12a1, and EML22a1, and is divided into an upper area Aus located on the upper side, a lower area Abs located on the lower side, a left area Als located on the left side, and a right area Ars located on the right side.

A portion located on the left side of FIG. 17 is an area between a corner portion of the first normal light emitting layers EML11a1, EML12a1, and EML22a1 and a recess portion of the first modified light emitting layer EML21a1, and is shown as a recess-side area Ald.

An equal sign, shown in the center of FIG. 17, indicates that the total sum of area shown on the right side of FIG. 17 and the area shown on the left side of FIG. 17 are equal to each other.

Therefore, the first modified light emitting layer EML21a1 and the first normal light emitting layers EML11a1, EML12a1, and EML22a1 all have the same size of their area.

Also, the first modified light emitting layer EML12a2 positioned in the unit pixel PXU12 shown in FIG. 16 may have the same characteristics as the first modified light emitting layer EML21a1.

That is, the first modified light emitting layer EML12a2 has the same area (or area size) as the first normal light emitting layers EML11a2, EML21a2, and EML22a2.

Here, since the lifespan of the light emitting layer is proportional to the planar area of the light emitting layer, all of the first light emitting layers EML11a1, EML12a1, EML21a1, EML22a1, EML11a2, EML12a2, EML21a2, and EML22a2 may have the same lifespan.

The area of the first light emitting layer (EML11a1, EML12a1, EML21a1, EML22a1, EML11a2, EML12a2, EML21a2, EML22a2) may be formed in various ways according to the material constituting the light emitting layer.

Meanwhile, a difference in area between the two sides may occur due to dispersion or errors that may occur in the actual manufacturing process.

Here, the position of the edge of the light emitting layer may vary within 1 µm due to dispersion or error, and the area difference that may occur between the normal light emitting layer and the modified light emitting layer due to dispersion or error may have an area difference of up to 10%.

Although a difference in lifespan of the light emitting layer may occur due to the difference in area, this difference in lifespan may be negligible.

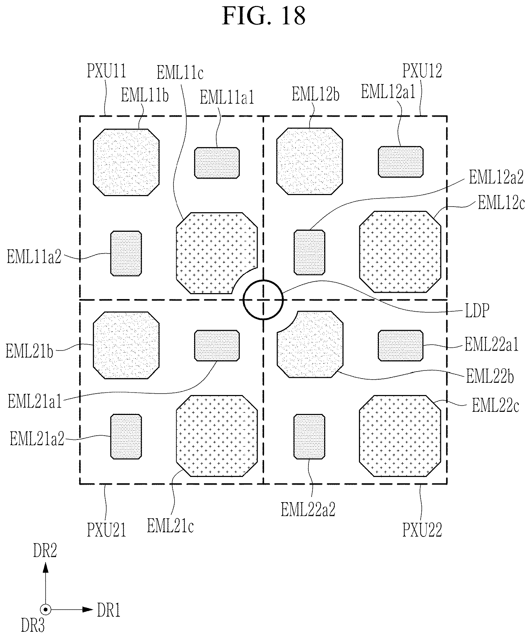

Meanwhile, in the embodiments of FIG. 18, embodiments in which the laser drilling position LDP is located at the center of four adjacent unit pixels PXU11, PXU12, PXU21, and PXU22 is illustrated.

That is, the center of the laser drilling position LDP and the points where all four unit pixels PXU11, PXU12, PXU21, and PXU22 meet may coincide with each other.

In this case, the distance of the modified light emitting layers EML11c and EML22b adjacent to the laser drilling position LDP from the laser drilling position LDP may be the same or different.

However, the gap or distance between the modified light emitting layers EML11c and EML22b and the laser drilling position LDP may be formed at a certain level or more to prevent damage to the light emitting layer during laser drilling.

Here, a certain level may be the half of the distance Gap1 between the normal light emitting layers, as seen in FIG. 7, when the distance Gap1 is considered 100, the distance between the laser drilling position LDP and the modified light emitting layer can have a value of 50 to 55.

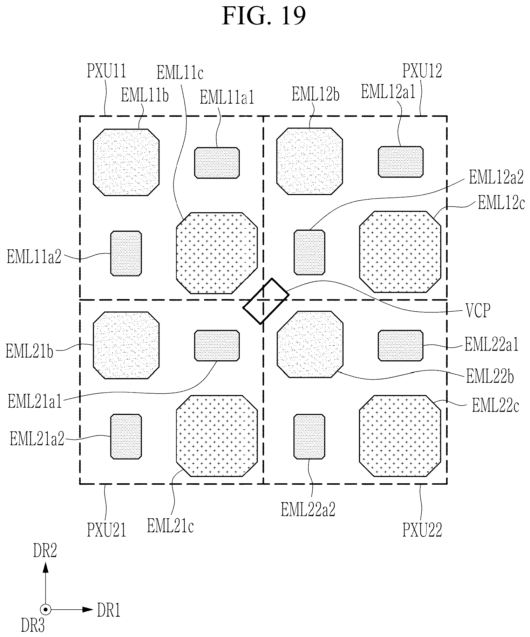

Meanwhile, in the embodiments of FIG. 19, a method of connecting a connecting electrode (CE of FIG. 24) and an entirely formed cathode using a laser drilling method will be described.

Referring to FIG. 19, after exposing the connecting electrode (CE in FIG. 24) to which the driving low-voltage ELVSS is transmitted through the opening VCP, the cathode is formed as a whole, and the driving low-voltage ELVSS is transmitted to the cathode through the opening VCP.

Here, the opening VCP may be smaller than the area of the laser drilling position LDP, the length of the diameter of the opening may have a value smaller than the distance Gap1, and when the distance Gap1 is 100, it may have a value of 30 or more and less than 100.

Also, the opening VCP may have a quadrangular planar shape as shown in FIG. 19.

In this case, the two light emitting layers EML11c and EML22b adjacent to the opening VCP may be formed as modified light emitting layers EML11c and EML22b, and each of the two light emitting layers EML11c and EML22b may have a side parallel to one side of the opening VCP.

Also, the area, which means the size of the area, of the modified light emitting layers EML11c and EML22b may be the same as that of the normal light emitting layer displaying the same color among other normal light emitting layers.

Meanwhile, according to embodiments, the opening VCP may have various planar shapes, such as a circular shape, unlike that shown in FIG. 19.

Although only one embodiment is shown in FIG. 19, all modified structures of the embodiment in which laser drilling is used in this application may also be applied.

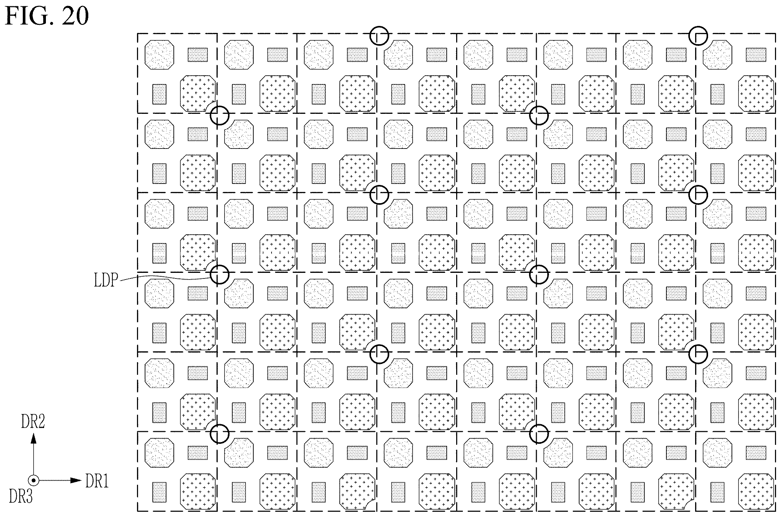

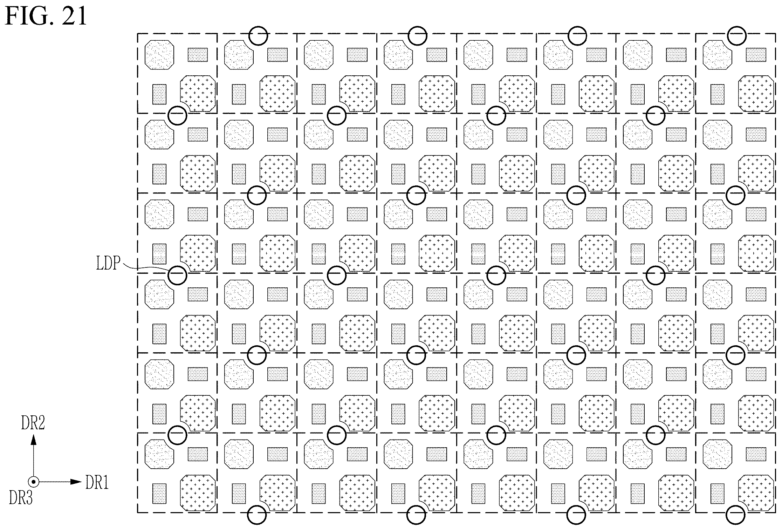

Meanwhile, in the embodiments of FIG. 20 and FIG. 21, embodiments in which the laser drilling position LDP is variously changed and arranged is shown.

First, in FIG. 20, as in the embodiments of FIG. 1, a modified embodiment of the embodiment in which laser drilling positions LDP are arranged over four adjacent unit pixels.

Referring to FIG. 20, if the laser drilling positions LDP are not continuously arranged in one direction but are alternately arranged with adjacent positions to connect four adjacent laser drilling positions LDP, a diamond shape may be obtained.

Meanwhile, FIG. 21 is a modified embodiment of the embodiment in which the laser drilling position LDP is arranged over two adjacent unit pixels, as in FIG. 11.

Referring to FIG. 21, when laser drilling positions LDP are alternately arranged and four adjacent laser drilling positions LDP are connected, a diamond shape may be obtained.

As shown in FIG. 20 and FIG. 21, in embodiments in which laser drilling positions LDP are alternately arranged at regular intervals, there may be an advantage in that no spots are formed.

That is, a connecting electrode (CE in FIG. 24) and a voltage line connected thereto must be formed through laser drilling. Depending on the laser drilling position LDP, a connecting electrode (CE in FIG. 24) and a voltage line connected thereto may also be formed.

However, in the case of a row in which a connecting electrode (CE of FIG. 24) and a voltage line connected thereto are not positioned, a stain may occur in some pixel rows.

However, as in the embodiments of FIG. 20 and FIG. 21, when the laser drilling positions LDP are alternately arranged at regular intervals, stains may not occur.

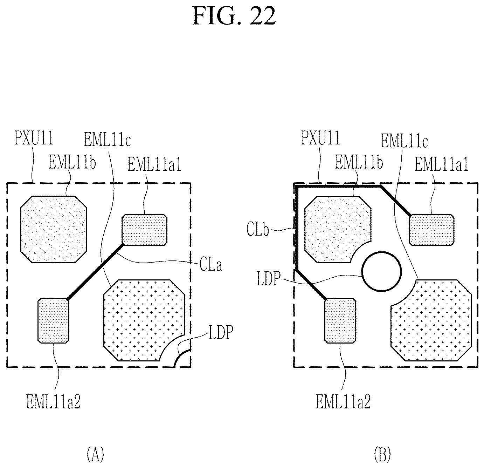

On the other hand, in FIG. 22, the connection of two light emitting layers (first-1 light emitting layers EML11a1, EML12a1, EML21a1, EML22a1 and first-2 light emitting layers EML11a2, EML12a2, EML21a2, EML22a2) positioned within one unit pixel PXU11, PXU12, PXU21, PXU22 may display the same color, this is a schematic drawing of the structure.

The first-1 light emitting layers EML11a1, EML12a1, EML21a1 and EML22a1 and the first-2 light emitting layers EML11a2, EML12a2, EML21a2 and EML22a2 are electrically connected to one pixel driving unit PCa to form two first-1 light emitting layers EML11a1, EML 12a1, EML21a1 and EML22a1, and the first and second light emitting layers (EML11a2, EML12a2, EML21a2, EML22a2) also need to be connected.

In FIG. 22, the description is centered on the unit pixel PXU11, in FIG. 22(A), the laser drilling position LDP is not located within the unit pixel PXU11, and in FIG. 22(B), the laser drilling position LDP is located within the unit pixel PXU11.

First, referring to FIG. 22(A), a light emitting device including the first-1 light emitting layer EML11a1 and a light emitting device including the first-2 light emitting layer EML11a2 may be electrically connected to each other by a connection line CLa passing through the central region of the unit pixel PXU11.

The connection line CLa may electrically connect the pixel driving unit (see PCa in FIG. 24) to an anode positioned under the first-1 light emitting layer EML11a1 and an anode positioned under the first-2 light emitting layer EML11a2.

The connection line CLa may be positioned on one of the conductive layers positioned between the substrate and the anode.

Meanwhile, referring to FIG. 22(B), a light emitting device including the first-1 light emitting layer EML11a1 and a light emitting device including the first-2 light emitting layer EML11a2 may be electrically connected to each other by a connection line CLb including a portion extending along the periphery of the unit pixel PXU11.

The connection line CLb may electrically connect the pixel circuit unit (refer to PCa in FIG. 24) to an anode positioned under the first-1 light emitting layer EML11a1 and an anode positioned under the first-2 light emitting layer EML11a2.

The connection line CLb may be positioned on one of the conductive layers positioned between the substrate and the anode.

In the above, it has been described that the anode of the light emitting device including the first-1 light emitting layer (EML11a1) and the anode of the light emitting device including the first-2 light emitting layer (EML11a2) are connected by the connection lines (CLa, CLb), however, according to some embodiments, the anode of one light emitting device and the cathode of another light emitting device may be connected, or may be connected to the cathodes of two light emitting devices.

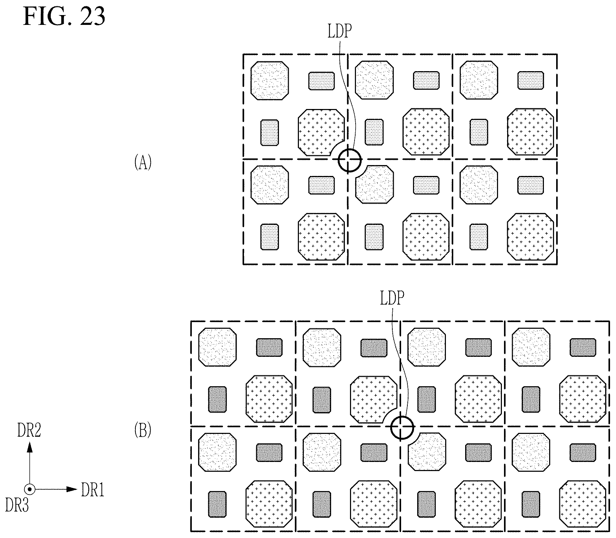

FIG. 23 illustrates embodiments in which the laser drilling position LDP is not formed for every 4 unit pixels.

A unit pixel group may refer to a group of unit pixels in which one laser drilling position LDP is formed, and the embodiments of FIG. 23 will be described in more detail.

FIG. 23(A) shows embodiments in which a unit pixel group includes 6 unit pixels, and embodiments in which laser drilling positions LDP are formed across 4 adjacent unit pixels among the 6 unit pixels is shown.

Meanwhile, in FIG. 23(B), an embodiment is shown where a unit pixel group includes 8 unit pixels, and an embodiment is shown where the laser drilling position LDP is formed across four adjacent unit pixels located in the center of the 8 unit pixels.

According to some embodiments, the laser drilling position LDP may also be positioned at the same position as in the embodiments of FIG. 11, FIG. 12, and FIG. 18 among unit pixel groups.

According to some embodiments, the number of unit pixels included in a unit pixel group may be various, other than 4, 6, and 8.

At this time, the laser drilling positions LDP may be formed for each unit pixel of various numbers, other than 4, 6, and 8 positions.

In the foregoing, various embodiments of the light emitting display device have been described, focusing on the structure of the light emitting layer included in the light emitting device and the structure for applying voltage to the cathode.

Hereinafter, a schematic planar structure of a pixel driving unit positioned under a light emitting device will be described through FIG. 24.

FIG. 24 is a schematic plan view of the lower part of the light emitting device of the light emitting display device according to some embodiments.

FIG. 24 illustrates a portion of the display area, and one pixel includes a light emitting device and a pixel driving unit.

In FIG. 24, the light emitting device is not shown, and the structure of the pixel driving unit positioned under the light emitting device is mainly shown.

In FIG. 24, a total of three pixel driving units PCa, PCb, and PCc adjacent to each other by dotted lines are schematically shown in each unit pixel PXU.

Each of the three pixel driving units PCa, PCb, and PCc constitutes a pixel driving unit of the unit pixel PXU, and a total of four unit pixels PXU are shown in FIG. 24.

In embodiments described below, four unit pixels PXU are collectively referred to as one unit pixel group.

One unit pixel PXU may include three pixels corresponding to three primary colors.

Each of the three pixel driving units PCa, PCb, and PCc belonging to one unit pixel PXU may have a structure extending in the first direction DR1, and each of the three may be pixel driving units PCa, PCb, and PCc corresponding to a pixel displaying three primary colors of light.

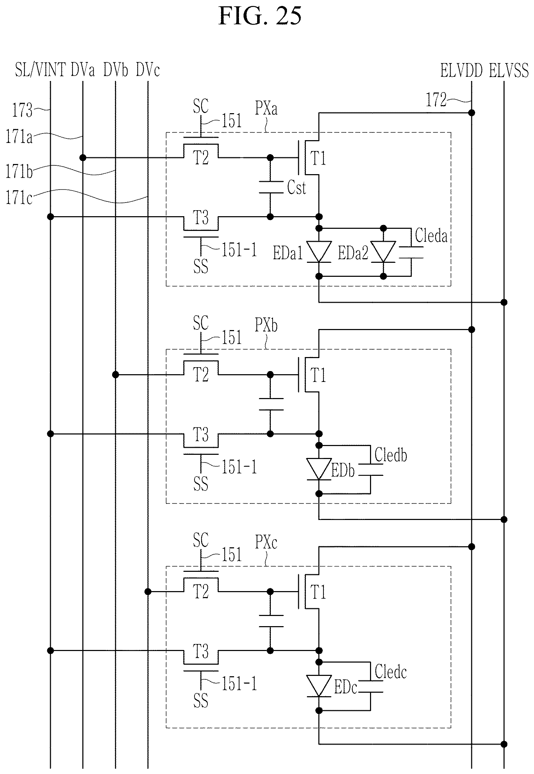

Structures of the pixel driving units PCa, PCb, and PCc may vary, and according to some embodiments may have the same circuit structure as that of FIG. 25.

In FIG. 24, some wirings additionally connected to the pixel driving units PCa, PCb, and PCc are additionally shown.

FIG. 24 shows the first scan signal line 151 and the second scan signal line 151-1 extending in the first direction DR1, and also the data lines 171a, 171b, and 171c, the driving voltage line 172, the initialization voltage line 173, and the driving low-voltage line 174 (hereinafter referred to as the second driving voltage line) extending in the second direction DR2 are shown.

Here, the pixel driving units PCa, PCb, and PCc may be commonly connected to the first scan signal line 151, the second scan signal line 151-1, the driving voltage line 172, the initialization voltage line 173, and the driving low-voltage line 174.

Also, the first pixel driving unit PCa may be connected to the first data line 171a, the second pixel driving unit PCb may be connected to the second data line 171b, and the third pixel driving unit PCc may be connected to the third data line 171c.

Each of the pixel driving units PCa, PCb, and PCc may correspond to each area in which a planar area partitioned by the first scan signal line 151 and the second scan signal line 151-1, and the driving low-voltage line 174 is divided into three areas.

Meanwhile, in FIG. 24, an auxiliary driving low-voltage line 174-1 (hereinafter referred to as an auxiliary second driving voltage line) extending in the first direction DR1 is also shown.

The auxiliary driving low-voltage line 174-1 is positioned on a different conductive layer from the driving low-voltage line 174, and extends in a different direction.

For example, the auxiliary driving low-voltage line 174-1 is connected to the driving low-voltage line 174 extending in the second direction DR2, and the driving low-voltage ELVSS can be transmitted in the first and second directions DR1 and DR2, so that a constant level of the driving low-voltage ELVSS can be applied over the entire display area of the light emitting display device.

The driving low-voltage ELVSS should also be applied to the cathode of the light emitting device.

Referring to FIG. 10, the cathode is above the pixel defining layer (see 380 in FIG. 10) and is positioned at the top in the third direction DR3.

A laser drilling method may be used in this embodiment to electrically connect the uppermost cathode and the auxiliary driving low-voltage line 174-1.

The laser drilling method is a method of irradiating a laser in a state where the cathode is formed and melting the irradiated portion so that the auxiliary driving low-voltage line 174-1 located at the bottom and the cathode are electrically connected.

In the embodiments of FIG. 24, the connecting electrode CE is formed between the auxiliary driving low-voltage line 174-1 and the cathode in cross-section to mediate electrical connection between the auxiliary driving low-voltage line 174-1 and the cathode.

For example, in the embodiments of FIG. 24, the connecting electrode CE is electrically connected to the auxiliary driving low-voltage line 174-1 through the opening OP1.

The connecting electrode CE is electrically connected to the cathode through laser drilling.

As a result, the cathode may receive the driving low-voltage ELVSS through the auxiliary driving low-voltage line 174-1.

According to some embodiments, the connecting electrode CE may correspond to a position where laser drilling occurs on a plane.

In addition, the first scan signal line 151 and the second scan signal line 151-1 overlapped the connecting electrode CE on a plane, but located below, are blocked by the connecting electrode CE during laser drilling, so that they are not short-circuited with the connecting electrode CE, and the driving low-voltage ELVSS is not transmitted.

Therefore, when the connecting electrode CE is used, the wiring can be formed below the area where laser drilling is performed, so that the wiring and element can be formed in a small area, thereby improving the degree of integration.

Meanwhile, according to some embodiments, a separate opening may be formed to electrically connect the cathode and the connecting electrode CE.

Meanwhile, in embodiments in which the position of the laser drilling position LDP is changed as in various embodiments described above, the positions of the auxiliary driving low-voltage line 174-1 and the connecting electrode CE may be changed together.

A light emitting device (or light emitting area) may be positioned on the third direction DR3 of the pixel driving units PCa, PCb, and PCc.

In the embodiments of FIG. 1, the planar shape of each light emitting layer (EML11a1, EML12a1, EML21a1, EML22a1, EML11a2, EML12a2, EML21a2, EML22a2, EML11b, EML12b, EML21b, EML22b, EML11c, EML12c, EML21c, EML22c) of the light emitting device is shown

The first pixel driving unit PCa may be electrically connected to the first-1 light emitting device including the first-1 light emitting layers EML11a1, EML12a1, EML21a1, and EML22a1 and the first-2 light emitting device including the 1-2 light emitting layers EML11a2, EML12a2, EML21a2, and EML22a2.

Here, the first-1 light emitting device and the first-2 light emitting device may be connected by connection lines CLa and CLb shown in FIG. 22.

Meanwhile, the second pixel driving unit PCb may be electrically connected to the second light emitting device including the second light emitting layers EML11b, EML12b, EML21b, and EML22b, and the third pixel driving unit PCc may be electrically connected to the third light emitting device including the third light emitting layers EML11c, EML12c, EML21c, and EML22c.

Connections between the pixel driving units PCa, PCb, and PCc and each light emitting device and the circuit structure of each pixel driving unit PCa, PCb, and PCc will be described in more with respect to FIG. 25.

FIG. 25 is a circuit drawing of a pixel of a light emitting display device according to some embodiments.

FIG. 25 shows a circuit drawing of three pixels PXa, PXb, and PXc.

The plurality of pixels may include a first pixel PXa, a second pixel PXb, and a third pixel PXc.

Each of the first pixel PXa, the second pixel PXb, and the third pixel PXc includes a plurality of transistors T1, T2, and T3, a storage capacitor Cst, and light emitting devices EDa1, EDa2, EDb, and EDc.

Here, one pixel (PXa, PXb, PXc) may be divided into light emitting devices (EDa1, EDa2, EDb, EDc) and pixel driving units (PCa, PCb, PCc), and the pixel driving units (PCa, PCb, PCc) may correspond to the portion shown by the dotted line in FIG. 24.

Referring to FIG. 25, the pixel driving units PCa, PCb, and PCc may include a plurality of transistors T1, T2, and T3 and a storage capacitor Cst corresponding to portions of the pixels PXa, PXb, and PXc excluding the light emitting devices EDa1, EDa2, EDb, and EDc.

Also, according to some embodiments, it may further include capacitors (Cleda, Cledb, Cledc; hereinafter referred to as light emitting part capacitors) connected at both ends of the light emitting devices EDa1, EDa2, EDb, EDc, the light emitting part capacitors (Cleda, Cledb, Cledc) may not be included in the pixel driving part, and can be included in the light emitting devices EDa1, EDa2, EDb, EDc.

For example, the first pixel driving unit PCa may be electrically connected to the first-1 and the first-2 light emitting devices EDa1 and the first-2 light emitting device EDa2, the second pixel driving unit PCb may be electrically connected to the second light emitting device EDb, and the third pixel driving unit PCc may be electrically connected to the third light emitting device EDc.

A detailed circuit structure of the pixel driving units PCa, PCb, and PCc according to the embodiments of FIG. 25 is as follows.

The plurality of transistors T1, T2, and T3 are formed of one driving transistor T1 (also referred to as a first transistor) and two switching transistors T2 and T3, and the two switching transistors are divided into an input transistor T2 (also referred to as a second transistor) and an initialization transistor (T3; also referred to as a third transistor).

Each transistor (T1, T2, T3) includes a gate electrode, a first electrode, and a second electrode, and also includes a semiconductor layer containing a channel, so that current flows or is blocked in the channel of the semiconductor layer depending on the voltage of the gate electrode.

Here, one of the first electrode and the second electrode may be a source electrode, and the other may be a drain electrode according to a voltage applied to each of the transistors T1, T2, and T3.

The gate electrode of the driving transistor T1 is connected to one end of the storage capacitor Cst and also connected to the second electrode (output side electrode) of the input transistor T2.

In addition, the first electrode of the driving transistor T1 is connected to the driving voltage line 172 that transmits the driving voltage ELVDD, and the second electrode of the driving transistor T1 is connected to the anodes of the light emitting devices EDa1, EDa2, EDb, and EDc, the other end of the storage capacitor Cst, the first electrode of the initialization transistor T3, and one end of the light emitting part capacitors Cleda, Cledb, and Cledc.

The driving transistor T1 receives the data voltages DVa, DVb, and DVc to the gate electrode according to the switching operation of the input transistor T2, and supplies driving current to the light emitting devices EDa1, EDa2, EDb, and EDc according to the voltage of the gate electrode.

At this time, the storage capacitor Cst stores and maintains the voltage of the gate electrode of the driving transistor T1.

A gate electrode of the input transistor T2 is connected to the first scan signal line 151 transmitting the first scan signal SC.

A first electrode of the input transistor T2 is connected to data lines 171a, 171b, and 171c transmitting data voltages DVa, DVb, and DVc, and a second electrode of the input transistor T2 is connected to one end of the storage capacitor Cst and the gate electrode of the driving transistor T1.

The plurality of data lines 171a, 171b, and 171c transfer different data voltages DVa, DVb, and DVc, respectively, and the input transistor T2 of each pixel PXa, PXb, and PXc is connected to the different data lines 171a, 171b, and 171c.

The gate electrodes of the input transistors T2 of each pixel PXa, PXb, and PXc are connected to the same first scan signal line 151, allowing them to receive the same timing of the first scan signal SC.

Even though the input transistors T2 of the pixels PXa, PXb, and PXc are simultaneously (or concurrently) turned on by the first scan signal SC at the same timing, the different data voltages DVa, DVb, and DVc are transferred to the gate electrode of the driving transistor T1 and one end of the storage capacitor Cst of the pixels PXa, PXb, and PXc through the different data lines 171a, 171b, and 171c.

FIG. 25 illustrates embodiments in which the gate electrode of the initialization transistor T3 receives a scan signal different from that of the gate electrode of the input transistor T2.

The gate electrode of the initialization transistor T3 is connected to the second scan signal line 151-1 transmitting the second scan signal SS.

The first electrode of the initialization transistor T3 is connected to the other end of the storage capacitor Cst, the second electrode of the driving transistor T1, the anodes of the light emitting devices EDa1, EDa2, EDb, and EDc, and one end of the light emitting part capacitors Cleda, Cledb, and Cledc, and the second electrode of the initialization transistor T3 is connected to the initialization voltage line 173 that transmits the initialization voltage VINT.

The initialization transistor T3 is turned on according to the second scan signal SS and transfers the initialization voltage VINT to the anodes of the light emitting devices EDa1, EDa2, EDb, and EDc, one end of the light emitting unit part capacitors Cleda, Cledb, and Cledc, and the other end of the storage capacitor Cst to initialize the voltages of the anodes of the light emitting devices EDa1, EDa2, EDb, and EDc.

The initialization voltage line 173 may function as a sensing line SL by performing an operation of sensing the voltages of the anodes of the light emitting devices EDa1, EDa2, EDb, and EDc before applying the initialization voltage VINT.

Through the sensing operation, it may be confirmed whether the voltage of the first anode is maintained at the target voltage.

The sensing operation and the initialization operation of transmitting the initialization voltage VINT may be separated in time, and the initialization operation may be performed after the sensing operation is performed.

In the embodiments of FIG. 25, the turn-on period of the initialization transistor T3 and the input transistor T2 can be distinguished, so that the writing operation performed by the input transistor T2 and the initialization operation (and/or sensing operation) performed by the initialization transistor T3 can be performed at different timings.

One end of the storage capacitor Cst is connected to the gate electrode of the driving transistor T1 and the second electrode of the input transistor T2, and the other end is connected to the first electrode of the initialization transistor T3, the second electrode of the driving transistor T1, the anodes of the light emitting devices EDa1, EDa2, EDb, and EDc, and one end of the light emitting part capacitors Cleda, Cledb, and Cledc.

The light emitting devices EDa1, EDa2, EDb, and EDc receive the output current of the driving transistor T1 at the anode, the cathodes of the light emitting elements EDa1, EDa2, EDb, and EDc receive the driving low-voltage ELVSS through the driving low-voltage line 174, and the light emitting devices EDa1, EDa2, EDb, and EDc emit light to display modulation according to the output current of the driving transistor T1.

In addition, the light emitting part capacitors Cleda, Cledb, and Cledc are formed at both ends of the light emitting devices EDa1, EDa2, EDb, and EDc so that the voltage across the light emitting devices EDa1, EDa2, EDb, and EDc can be maintained constant so that the light emitting devices EDa1, EDa2, EDb, and EDc can display constant luminance.

Hereinafter, an operation of a pixel having a circuit as shown in FIG. 25 will be briefly described.

In FIG. 25, each of the transistors T1, T2, and T3 is an N-type transistor, and is turned on when a high-level voltage is applied to the gate electrode.

However, according to some embodiments, each of the transistors T1, T2, and T3 may be a P-type transistor.

When the emission section ends, one frame begins.

After that, the high-level second scan signal SS is supplied to turn on the initialization transistor T3.

When the initialization transistor T3 is turned on, an initialization operation and/or a sensing operation may be performed.

Embodiments in which both an initialization operation and a detection operation are performed will be described below.

The sensing operation may be performed first before the initialization operation is performed.

That is, when the initialization transistor T3 is turned on, the initialization voltage line 173 serves as a sensing line SL to sense the voltages of the anodes of the light emitting devices EDa1, EDa2, EDb, and EDc.

Through the sensing operation, it may be confirmed whether the voltage of the anode is maintained at the target voltage.

After that, an initialization operation may be performed, and the voltage of the other terminal of the storage capacitor Cst, the second electrode of the driving transistor T1, and the anodes of the light emitting devices EDa1, EDa2, EDb, and EDc are changed to the initialization voltage VINT transmitted from the initialization voltage line 173 to perform initialization.

As described above, the sensing operation and the initialization operation of transmitting the initialization voltage VINT are separated in time, so that the pixel can perform various operations while using a minimum number of transistors and reducing the area occupied by the pixel.

As a result, resolution of the display panel may be improved.

Along with the initialization operation or at a separate timing, the first scan signal SC is also changed to a high level and applied, the input transistor T2 is turned on, and a writing operation is performed.

That is, the data voltages DVa, DVb, and DVc from the data lines 171a, 171b, and 171c are input to the gate electrode of the driving transistor T1 and one end of the storage capacitor Cst through the turned-on input transistor T2 is stored.

The data voltages DVa, DVb, and DVc and the initialization voltage VINT are applied to both ends of the storage capacitor Cst by the initialization operation and the writing operation.

In a state in which the initialization transistor T3 is turned on, even if an output current is generated by the driving transistor T1, it may be output to the outside through the initialization transistor T3 and the initialization voltage line 173, so that it may not be input to the first anode of the first light emitting devices EDa1, EDb1, and EDc1.

In addition, according to some embodiments, during the writing period in which the first scan signal SC of high level is supplied, the driving voltage ELVDD may be applied as a low-level voltage or the driving low-voltage ELVSS may be applied as a high-level voltage so that current does not flow through the light emitting devices EDa1, EDa2, EDb, and EDc.

Then, when the first scan signal SC is changed to a low level, the driving transistor T1 generates and outputs an output current according to high-level voltage of the driving voltage ELVDD applied to the driving transistor T1 and the gate voltage of the driving transistor T1 stored in the storage capacitor Cst.

The output current of the driving transistor T1 is input to the light emitting devices EDa1, EDa2, EDb, and EDc, and a light emitting period in which the light emitting devices EDa1, EDa2, EDb, and EDc emit light proceeds.

The embodiments of the light emitting display device as described above may be included in an electronic device, and the light emitting display device according to the present embodiments may be used in a medium-sized electronic device such as a monitor or a TV.

However, examples of electronic devices are not limited thereto.

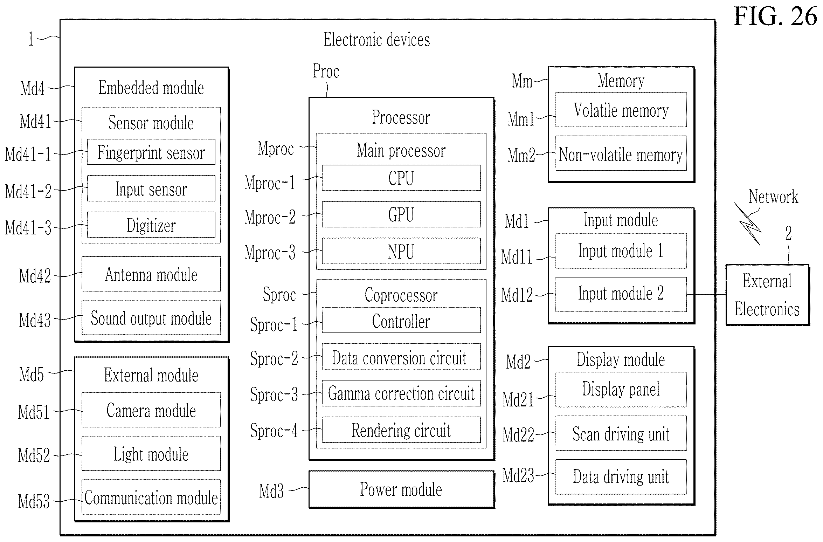

Hereinafter, an embodiment of one electronic device in which the light emitting display device according to the present embodiments may be included will be reviewed through FIG. 26.

FIG. 26 is a block drawing of an electronic device according to embodiments.

The electronic device 1 outputs various information through the display module MD2 within the operating system.

When the processor PROC executes the application stored in the memory MM, the display module MD2 provides application information to the user through the display panel MD21.

Here, the light emitting display device described above may be used as the display panel MD21.

The processor PROC obtains an external input through the input module MD1 or the sensor module MD41, and executes an application corresponding to the external input.

For example, when the user selects a camera icon displayed on the display panel MD21, the processor PROC obtains a user input through the input sensor MD41-2 and activates the camera module MD51.

The processor PROC transfers image data corresponding to the photographic image acquired through the camera module MD51 to the display module MD2.

The display module MD2 may display an image corresponding to the captured image through the display panel MD21.

As another example, when personal information authentication is executed in the display module MD2, the fingerprint sensor MD41-1 obtains input fingerprint information as input data.

The processor PROC compares the input data acquired through the fingerprint sensor MD41-1 with authentication data stored in the memory MM, and executes an application according to the comparison result.

The display module MD2 may display information executed according to application logic through the display panel MD21.

As another example, when the music streaming icon displayed on the display module MD2 is selected, the processor PROC obtains a user input through the input sensor MD41-2 and activates a music streaming application stored in the memory MM.

When a music execution command is input in the music streaming application, the processor PROC activates the sound output module MD43 to provide sound information corresponding to the music execution command to the user.

In the above, the operation of the electronic device 1 has been briefly described.

Hereinafter, the configuration of the electronic device 1 will be described in detail.

Some of the components of the electronic device 1 described later may be integrated and provided as one component, or one component may be provided separately as two or more components.

Referring to FIG. 26, the electronic device 1 may communicate with an external electronic device 2 through a network (e.g., a short-distance wireless communication network or a long-distance wireless communication network).

According to some embodiments, the electronic device 1 may include a processor PROC, a memory MM, an input module MD1, a display module MD2, a power module MD3, an embedded module MD4, and an external module MD5.

According to some embodiments, in the electronic device 1, at least one of the above-described components may be omitted, or one or more other components may be added.

According to some embodiments, some of the above-described components (e.g., sensor module MD41, antenna module MD42, or sound output module MD43) may be integrated into another component (e.g., display module MD2).

The processor PROC may execute software to control at least one other component (e.g., hardware or software component) of the electronic device 1 connected to the processor PROC, and may perform various data processing or calculations.

According to some embodiments, as at least part of data processing or operation, the processor PROC may store commands or data received from other components (e.g., input module MD1, sensor module MD41, or communication module MD53) in volatile memory MM1, process the commands or data stored in volatile memory MM1, and store the resulting data in non-volatile memory MM2.

The processor PROC may include a main processor MPROC and an auxiliary processor SPROC.

The main processor MPROC may include one or more of a central processing unit (MPROC-1) or an application processor (AP).

The main processor MPROC may further include one or more of a graphic processing unit (MPROC-2), a communication processor (CP), and an image signal processor (ISP).

The main processor MPROC may further include a neural processing unit (NPU; MPROC-3).

A neural network processing device is a processor specialized in processing an artificial intelligence model, and the artificial intelligence model may be generated through machine learning.

The artificial intelligence model may include a plurality of artificial neural network layers.

The artificial neural network may be one of a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-networks, or a combination of two or more of the above, but is not limited to the above examples.

The artificial intelligence model may include, in addition or alternatively, software structures as well as hardware structures.

At least two of the above-described processing unit and processor may be implemented as an integrated component (e.g., a single chip) or each may be implemented as an independent component (e.g., a plurality of chips).

The auxiliary processor SPROC may include a controller SPROC-1.

The controller SPROC-1 may include an interface conversion circuit and a timing control circuit.

The controller SPROC-1 receives the video signal from the main processor MPROC, converts the data format of the video signal to meet the interface specification with the display module MD2, and outputs video data.

The controller SPROC-1 can output various control signals required to drive the display module MD2.

The auxiliary processor SPROC may further include a data conversion circuit SPROC-2, a gamma correction circuit SPROC-3, a rendering circuit SPROC-4, and the like.

The data conversion circuit SPROC-2 receives image data from the controller SPROC-1, compensates the image data so that the image is displayed with a desired luminance according to the characteristics of the electronic device 1 or user settings, or converts the image data to reduce power consumption or compensate for afterimages.

The gamma correction circuit SPROC-3 may convert image data or a gamma reference voltage so that an image displayed on the electronic device 1 has desired gamma characteristics.

The rendering circuit SPROC-4 may receive image data from the controller SPROC-1 and render the image data in consideration of the pixel arrangement of the display panel MD21 applied to the electronic device 1.

At least one of the data conversion circuit SPROC-2, the gamma correction circuit SPROC-3, or the rendering circuit SPROC-4 may be incorporated into other components (e.g., the main processor MPROC or the controller SPROC-1).

At least one of the data conversion circuit SPROC-2, the gamma correction circuit SPROC-3, or the rendering circuit SPROC-4 may be incorporated into a data driver MD23 described later.

The memory MM may store various data used by at least one component of the electronic device 1 (e.g., the processor PROC or the sensor module MD41) and input data or output data for a command related thereto.

The memory MM may include at least one of a volatile memory MM1 or a non-volatile memory MM2.

The input module MD1 may receive commands or data to be used in components of the electronic device 1 (e.g., the processor PROC, the sensor module MD41, or the sound output module MD43) from the outside of the electronic device 1 (e.g., a user or an external electronic device 2).

The input module MD1 may include a first input module MD11 for receiving a command or data from a user and a second input module MD12 for receiving a command or data from the external electronic device 2.

The first input module MD11 may include a microphone, mouse, keyboard, key (e.g., button), or pen (e.g., passive pen or active pen).

The second input module MD12 may support a designated protocol capable of being connected to the external electronic device 2 by wire or wirelessly.

According to some embodiments, the second input module MD12 may include a high-definition multimedia interface (HDMI), a universal serial bus (USB) interface, an SD card interface, or an audio interface.

The second input module MD12 may include a connector that can be physically connected to the external electronic device 2-for example, an HDMI connector, a USB connector, an SD card connector, or an audio connector (e.g., a headphone connector).

The display module MD2 provides visual information to the user.

The display module MD2 may include a display panel MD21, a scan driver MD22, and a data driver MD23.

The display module MD2 may further include a window, a chassis, and a bracket to protect the display panel MD21.

The display panel MD21 may include a liquid crystal display panel, an organic light emitting display panel, or an inorganic light emitting display panel, and the type of display panel MD21 is not particularly limited.

The display panel MD21 may be a rigid type or a flexible type capable of being rolled or folded.

The display module MD2 may further include a supporter, a bracket, or a heat-dissipation part that supports the display panel MD21.

The scan driver MD22 may be mounted on the display panel MD21 as a driving chip.

Also, the scan driver MD22 may be integrated into the display panel MD21.

For example, the scan driver MD22 can include an amorphous silicon transistor gate driver circuit (ASG), a low-temperature polycrystalline silicon transistor gate driver circuit (LTPS), or an oxide semiconductor transistor gate driver circuit (OSG) embedded in the display panel MD21.

The scan driver MD22 receives a control signal from the controller SPROC-1 and outputs scan signals to the display panel MD21 in response to the control signal.

The display panel MD21 may further include a light emitting driver.

The light emitting driver outputs a light emitting control signal to the display panel MD21 in response to the control signal received from the controller SPROC-1.

The light emitting driver may be formed separately from the scan driver MD22 or integrated into the scan driver MD22.

The data driver MD23 receives a control signal from the controller SPROC-1, converts image data into analog voltages (e.g., data voltages) in response to the control signal, and then outputs the data voltages to the display panel MD21.

The data driver MD23 may be incorporated into other components (e.g., controller SPROC-1).

The functions of the interface conversion circuit and timing control circuit of the controller SPROC-1 described above may be integrated into the data driver MD23.

The display module MD2 may further include a light driver and a voltage generator circuit.

The voltage generator circuit may output various voltages necessary for driving the display panel MD21.

The power module MD3 supplies power to components of the electronic device 1.

The power module MD3 may include a battery charging the power voltage.

The battery may include a non-rechargeable primary cell, a rechargeable secondary cell, or a fuel cell.

The power module MD3 may include a power management integrated circuit (PMIC).

The PMIC supplies optimized power to each of the above-described modules and modules described later.

The power module MD3 may include a wireless power transmission/reception part electrically connected to the battery.

The wireless power transmission/reception part may include a plurality of antenna radiators in the form of coils.

The electronic device 1 may further include an internal module MD4 and an external module MD5.

The internal module MD4 may include a sensor module MD41, an antenna module MD42, and a sound output module MD43.

The external module MD5 may include a camera module MD51, a light module MD52, and a communication module MD53.

The sensor module MD41 may detect an input by the user's body or an input by a pen among the first input modules MD11, and generate an electrical signal or data value corresponding to the input.

The sensor module MD41 may include at least one of a fingerprint sensor MD41-1, an input sensor MD41-2, or a digitizer MD41-3.

The fingerprint sensor MD41-1 may generate a data value corresponding to the user's fingerprint.

The fingerprint sensor MD41-1 may include either an optical or capacitive fingerprint sensor.

The input sensor MD41-2 may generate data values corresponding to coordinate information of an input by a user's body or a pen.

The input sensor (MD41-2) generates the amount of change in capacitance by the input as a data value.

The input sensor (MD41-2) can detect an input by a passive pen or transmit/receive data to/from an active pen.

The input sensor MD41-2 may measure biosignals such as blood pressure, moisture, or body fat.

For example, when the user touches a body part to a sensor layer or a sensing panel and does not move for a certain period of time, the input sensor MD41-2 detects a biosignal based on a change in an electric field caused by the body part, and outputs information desired by the user to the display module MD2.

The digitizer MD41-3 may generate data values corresponding to coordinate information input by the pen.

The digitizer (MD41-3) generates the amount of electromagnetic change by the input as a data value.

The digitizer (MD41-3) can detect input by the passive pen or transmit/receive data to/from the active pen.

At least one of the fingerprint sensor MD41-1, input sensor MD41-2, or digitizer MD41-3 may be implemented as a sensor layer formed on the display panel MD21 through a continuous process.

The fingerprint sensor MD41-1, the input sensor MD41-2, and the digitizer MD41-3 may be arranged above the display panel MD21, and any one of the fingerprint sensor MD41-1, the input sensor MD41-2, and the digitizer MD41-3-for example, the digitizer MD41-3-may be arranged below the display panel MD21.

At least two of the fingerprint sensor MD41-1, the input sensor MD41-2, and the digitizer MD41-3 may be integrated into one sensing panel through the same process.

When integrated into one sensing panel, the sensing panel may be located between the display panel MD21 and a window located above the display panel MD21.

According to some embodiments, the sensing panel may be located on the window, and the position of the sensing panel is not particularly limited.

At least one of the fingerprint sensor MD41-1, input sensor MD41-2, or digitizer MD41-3 may be embedded in the display panel MD21.

That is, at least one of the fingerprint sensor MD41-1, the input sensor MD41-2, or the digitizer MD41-3 may be simultaneously (or concurrently) formed through a process of forming elements included in the display panel MD21 (e.g., a light emitting device, a transistor, etc.).

In addition, the sensor module MD41 may generate an electrical signal or data value corresponding to an internal state or an external state of the electronic device 1.

The sensor module MD41 may further include, for example, a gesture sensor, a gyro sensor, an air-pressure sensor, a magnetic sensor, an acceleration sensor, a grip sensor, a proximity sensor, a color sensor, an IR (infrared) sensor, a bio sensor, a temperature sensor, a humidity sensor, or an illuminance sensor.

The antenna module MD42 may include one or more antennas for transmitting or receiving signals or power to the outside.

According to some embodiments, the communication module MD53 may transmit a signal to an external electronic device or receive a signal from an external electronic device through an antenna suitable for a communication method.

The antenna pattern of the antenna module MD42 may be integrated into one component of the display module MD2 (for example, the display panel MD21) or the input sensor MD41-2.

The sound output module MD43 is a device for outputting sound signals to the outside of the electronic device 1, and may include, for example, a speaker used for general purposes such as multimedia playback or recording playback, and a receiver used exclusively for receiving calls.

According to some embodiments, the receiver may be formed integrally with or separately from the speaker.

The sound output pattern of the sound output module MD43 may be integrated with the display module MD2.

The camera module MD51 may capture still images and moving images.

According to some embodiments, the camera module MD51 may include one or more lenses, image sensors, or image signal processors.

The camera module MD51 may further include an infrared camera capable of measuring the presence or absence of the user, the user's location, and the user's line of sight.

The light module MD52 may provide light.

The light module MD52 may include a light emitting diode or a xenon lamp.

The light module MD52 may operate in conjunction with the camera module MD51 or independently.

The communication module MD53 may support establishment of a wired or wireless communication channel between the electronic device 1 and the external electronic device 2 and communication through the established communication channel.

The communication module MD53 may include any one or all of a wireless communication module such as a cellular communication module, a short-range wireless communication module, or a global navigation satellite system (GNSS) communication module, a local area network (LAN) communication module, or a wired communication module such as a power line communication module.

The communication module MD53 may communicate with the external electronic device 2 through a short-distance communication network such as Bluetooth, WiFi direct, or infrared data association (IrDA) or a long-distance communication network such as a cellular network, the Internet, or a computer network (e.g., LAN or WAN).

The various types of communication modules (MD53) described above may be implemented as one chip or may be implemented as separate chips.

The input module MD1, the sensor module MD41, the camera module MD51, and the like may be used to control the operation of the display module MD2 in conjunction with the processor PROC.

The processor PROC outputs commands or data to the display module MD2, the sound output module MD43, the camera module MD51, or the light module MD52 based on the input data received from the input module MD1.

For example, the processor PROC may generate image data corresponding to input data applied through a mouse or an active pen and output the image data to the display module MD2, or generate command data corresponding to the input data and output the image data to the camera module MD51 or the light module MD52.

When input data is not received from the input module MD1 for a certain period of time, the processor PROC converts the operation mode of the electronic device 1 into a low-power mode or a sleep mode to reduce power consumed by the electronic device 1.

The processor PROC outputs commands or data to the display module MD2, the sound output module MD43, the camera module MD51, or the light module MD52 based on the sensing data received from the sensor module MD41.

For example, the processor PROC may compare authentication data applied by the fingerprint sensor MD41-1 with authentication data stored in the memory MM, and then execute an application according to the comparison result.

The processor PROC may execute a command or output corresponding image data to the display module MD2 based on the sensing data sensed by the input sensor MD41-2 or the digitizer MD41-3.

When the sensor module MD41 includes a temperature sensor, the processor PROC may receive temperature data for the temperature measured from the sensor module MD41 and further perform luminance correction on the image data based on the temperature data.

The processor PROC may receive measurement data about the presence or absence of the user, the location of the user, and the gaze of the user from the camera module MD51.

The processor PROC may further perform luminance correction on the image data based on the measurement data.

For example, the processor PROC, which determines whether or not there is a user through an input from the camera module MD51, outputs image data whose luminance is corrected through the data conversion circuit SPROC-2 or the gamma correction circuit SPROC-3 to the display module MD2.

Some of the components may be connected to each other through a communication method between peripheral devices-for example, a bus, general purpose input/output (GPIO), serial peripheral interface (SPI), mobile industry processor interface (MIPI), or ultra path interconnect (UPI) link to exchange signals (e.g., commands or data) with each other.

The processor PROC may communicate with the display module MD2 through an agreed interface. For example, any one of the above communication methods may be used, and the above communication method is not limited thereto.

The electronic device 1 according to embodiments disclosed in this document may be various types of devices.

The electronic device 1 may include, for example, at least one of a portable communication device (e.g., a smart phone), a computer device, a portable multimedia device, a portable medical device, a camera, a wearable device, or a home appliance.

The electronic device 1 according to the embodiments of this document is not limited to the aforementioned devices.

Although the embodiments have been described in more detail above, the scope of embodiments according to the present disclosure is not limited thereto, and various modifications and improvements of those skilled in the art using the basic concepts of the present embodiments defined in the following claims are also within the scope of the present embodiments according to the present claims.

## Claims

1. A light emitting display device, comprising:
a unit pixel group having at least two unit pixels (PXU11, PXU12, PXU21, PXU22),
wherein a unit pixel (PXU11, PXU12, PXU21, PXU22) from among the at least two unit pixels (PXU11, PXU12, PXU21, PXU22) includes a first light emitting layer (EML11a1, EML12a1, EML21a1, EML22a1, EML11a2, EML12a2, EML21a2, EML22a2), a second light emitting layer (EML11b, EML12b, EML21b, EML22b), and a third light emitting layer (EML11c, EML12c, EML21c, EML22c) corresponding to three primary colors,
the first light emitting layer (EML11a1, EML12a1, EML21a1, EML22a1, EML11a2, EML12a2, EML21a2, EML22a2) includes two sub-light emitting layers (EML11a1, EML12a1, EML21a1, EML22a1, EML11a2, EML12a2, EML21a2, EML22a2) in one unit pixel (PXU11, PXU12, PXU21, PXU22),
at least one electrical connection formed by a laser drilling position (LDP) in the unit pixel group configured to connect a cathode to an underlying electrical layer,
the unit pixel group comprises first, second and third light emitting layers (EML21a1, EML12a1, EML22b, EML11c) adjacent to the laser drilling position (LDP) and at least second and third light emitting layers (EML11b, EML12b, EML21b, EML12c, EML21c, EML22c) spaced apart from the laser drilling position (LDP),
**characterized in that** at least the second light emitting layer (EML22b) and the third light emitting layer (EML11c) adjacent to the laser drilling position (LDP) include a recess in a plan view, respectively, the recess faces to the laser drilling position (LDP) in a plan view,
the size of an area of the second light emitting layer (EML22b) adjacent to the laser drilling position (LDP) and the size of an area of the second light emitting layer (EML11b, EML12b, EML21b) spaced apart from the laser drilling position (LDP) have an area difference of greater than 0% and less than 10%, and
the size of an area of the third light emitting layer (EML11c) adjacent to the laser drilling position (LDP) and the size of an area of the third light emitting layer (EML12c, EML21c, EML22c) spaced apart from the laser drilling position (LDP) have an area difference of greater than 0% and less than 10%.

2. The light emitting display device of claim 1, wherein
the second light emitting layer (EML22b) and the third light emitting layer (EML11c) adjacent to the laser drilling position (LDP) are formed of a second modified light emitting layer (EML22b) and a third modified light emitting layer (EML11c) including the recess, respectively,
the second light emitting layer (EML11b, EML12b, EML21b) and the third light emitting layer (EML12c, EML21c, EML22c) spaced apart from the laser drilling position (LDP) are formed of a second normal light emitting layer (EML11b, EML12b, EML21 b) and a third normal light emitting layer (EML12c, EML21c, EML22c) that are free of a recess in a plan view, respectively.

3. The light emitting display device of claim 2, wherein:
a planar shape of the second normal light emitting layer (EML11b, EML12b, EML21b) and the third normal light emitting layer (EML12c, EML21c, EML22c) is a quadrangle shape, and corners are chamfered or rounded.

4. The light emitting display device of claim 1, wherein:
the second light emitting layer (EML11b, EML12b, EML21b) and the third light emitting layer (EML12c, EML21c, EML22c) spaced apart from the laser drilling position (LDP) have recesses positioned on a side different from a side on which the recesses are positioned in the second and third light emitting layers ( EML22b, EML11c) adjacent to the laser drilling position (LDP), respectively.

5. The light emitting display device of claim 4, wherein:
the unit pixel group includes four unit pixels (PXU11, PXU12, PXU21, PXU22),
the second light emitting layers (EML11b, EML12b, EML21b, EML22b) and the third light emitting layers (EML11c, EML12c, EML21c, EML22c) have a rectangular shape except for the recess, and have chamfered or rounded corners,
the unit pixel group includes four second light emitting layers (EML11b, EML12b, EML21 b, EML22b) and four third light emitting layers (EML11c, EML12c, EML21c, EML22c) with one second light emitting layer (EML22b) and one third light emitting layer (EML11c) adjacent to the laser drilling position (LDP), and
the recesses in the second light emitting layers (EML11b, EML12b, EML21 b, EML22b) of all second light emitting layers (EML11b, EML12b, EML21 b, EML22b) are positioned at different corners with respect to each other and/or the recesses in the third light emitting layers (EML11c, EML12c, EML21c, EML22c) of all third light emitting layers (EML11c, EML12c, EML21c, EML22c) are positioned at different corners with respect to each other.

6. The light emitting display device of claim 1 or 2, wherein:
the recess of the second light emitting layer (EML22b) adjacent to the laser drilling position (LDP) and the recess of the third light emitting layer (EML11c) adjacent to the laser drilling position (LDP) is formed at a side of the laser drilling position (LDP) of the second light emitting layer (EML22b) and the third light emitting layer (EML11c), respectively.

7. The light emitting display device of claim 6, wherein:
the recess is respectively formed at a corner portion of the second light emitting layer (EML22b) adjacent to the laser drilling position (LDP) facing the laser drilling position (LDP), and
at a corner portion of the third light emitting layer (EML11c) adjacent to the laser drilling position (LDP) facing the laser drilling position (LDP).

8. The light emitting display device of at least one of claims 1 to 7, wherein at least one recess or each recess facing the laser drilling position (LDP) has a concave shape, especially a circular arc shape, preferably concentric to a center of the laser drilling position (LDP) and/or an outer circumference of the laser drilling position (LDP), in a plan view.

9. The light emitting display device of at least one of claims 1 to 8, wherein:
the first light emitting layer (EML11a1, EML12a1, EML21a1, EML22a1, EML11a2, EML12a2, EML21a2, EML22a2) is formed of a first normal light emitting layer (EML11a1, EML12a1, EML21a1, EML22a1, EML11a2, EML12a2, EML21a2, EML22a2) that does not include recesses.

10. The light emitting display device of claim 9, wherein:
the first light emitting layer (EML11a1, EML12a1, EML21a1, EML22a1, EML11a2, EML12a2, EML21a2, EML22a2) included in one of the unit pixels (PXU11, PXU12, PXU21, PXU22) includes a first-1 light emitting layer (EML11a1, EML12a1, EML21a1, EML22a1) and a first-2 light emitting layer (EML11a2, EML12a2, EML21a2, EML22a2),
the first-1 light emitting layer EML11a1, EML12a1, EML21a1, EML22a1) and the first-2 light emitting layer (EML11a2, EML12a2, EML21a2, EML22a2) each have a rectangular shape in a plan view, and have chamfered or rounded corners,
a direction in which the first-1 light emitting layer EML11a1, EML12a1, EML21a1, EML22a1) is elongated is different from a direction in which the first-2 light emitting layer (EML11a2, EML12a2, EML21a2, EML22a2) is elongated.

11. The light emitting display device of claim 10, wherein:
a light emitting device including the first-1 light emitting layer EML11a1, EML12a1, EML21a1, EML22a1) and a light emitting device including the first-2 light emitting layer (EML11a2, EML12a2, EML21a2, EML22a2) are electrically connected to the same pixel driving unit (PCa, PCb, PCc) through a connection line (CLa, CLb), and are included in one of the unit pixels (PXU11, PXU12, PXU21, PXU22).

12. The light emitting display device of claim 11, wherein:
the laser drilling position (LDP) is positioned in a center area of a unit pixel (PXU11, PXU12, PXU21, PXU22), and a portion of the connection line (CLb) extends along an outer edge of the unit pixel (PXU11, PXU12, PXU21, PXU22).

13. The light emitting display device of at least one of claims 1 to 12, wherein:
a first light emitting layer (EML21a1, EML12a2) adjacent to the laser drilling position (LDP) is formed as a first modified light emitting layer (EML21a1, EML12a2) including a recess in a plan view, and a first light emitting layer (EML11a1, EML12a1, EML22a1, EML11a2, EML21a2, EML22a2) spaced apart from the laser drilling position (LDP) is formed as a first normal light emitting layer (EML11a1, EML12a1, EML22a1, EML11a2, EML21a2, EML22a2) without a recess in a plan view,
the size of an area of the first modified light emitting layer (EML21a1, EML12a2) and the size of an area of the first normal light emitting layer (EML11a1, EML12a1, EML22a1, EML11a2, EML21a2, EML22a2) are the same or have an area difference of less than 10%.

14. The light emitting display device of claim 13, wherein:
the first normal light emitting layer (EML11a1, EML12a1, EML22a1, EML11a2, EML21a2, EML22a2) has a rectangular shape in a plan view, and has chamfered or rounded corners,
two first modified light emitting layers (EML21a1, EML12a2) are included in one unit pixel (PXU11, PXU12, PXU21, PXU22), and
the two first modified light emitting layers (EML21a1, EML12a2) are elongated and have different directions.

15. The light emitting display device of at least one of claims 2 or 6 to 14, when not dependent on claim 4, wherein:
the second modified light emitting layer (EML22b) extends in a straight line at the corners facing the second normal light emitting layer (EML11b, EML12b, EML21b), in a plan view, and
the third modified light emitting layer extends in a straight line at a corner portion facing the third normal light emitting layer (EML12c, EML21c, EML22c), in a plan view.

16. The light emitting display device of at least one of claims 1 to 15, wherein:
the unit pixel group includes four unit pixels (PXU11, PXU12, PXU21, PXU22), and
the laser drilling position (LDP) is positioned over all of the four unit pixels (PXU11, PXU12, PXU21, PXU22)and optionally, wherein:
a center of the laser drilling position (LDP) is positioned in one of the four unit pixels (PXU11, PXU12, PXU21, PXU22), or
a center of the laser drilling position (LDP) is positioned at a point where the four unit pixels (PXU11, PXU12, PXU21, PXU22) meet, or wherein
the unit pixel group includes four unit pixels (PXU11, PXU12, PXU21, PXU22), and
the laser drilling position (LDP) is positioned across one or two of the four unit pixels (PXU11, PXU12, PXU21, PXU22)

17. The light emitting display device of at least on of claims 1 to 16, wherein:
the laser drilling positions (LDP) are different from each other in at least two different unit pixel groups.

18. The light emitting display device of at least on of claims 1 to 17, wherein a distance between the recess portion of the third light emitting layer (EML11c) and a recess portion of the second light emitting layer (EML22b) has a size that is up to twice that of a distance (Gap1) between the first light emitting layer (EML11a1, EML12a1, EML21a1, EML22a1, EML11a2, EML12a2, EML21a2, EML22a2) and the third light emitting layer (EML11b, EML12b, EML21b, EML12c, EML21c, EML22c).

## Patentansprüche

1. Lichtemittierende Anzeigevorrichtung, umfassend:
eine Einheitspixelgruppe mit mindestens zwei Einheitspixeln (PXU11, PXU12, PXU21, PXU22),
wobei ein Einheitspixel (PXU11, PXU12, PXU21, PXU22) aus den mindestens zwei Einheitspixeln (PXU11, PXU12, PXU21, PXU22) eine erste lichtemittierende Schicht (EML11a1, EML12a1, EML21a1, EML22a1, EML11a2, EML12a2, EML21a2, EML22a2), eine zweite lichtemittierende Schicht (EML11b, EML12b, EML21b, EML22b) und eine dritte lichtemittierende Schicht (EML11c, EML12c, EML21c, EML22c) beinhaltet, die drei Primärfarben entsprechen,
die erste lichtemittierende Schicht (EML11a1, EML12a1, EML21 a1, EML22a1, EML11a2, EML12a2, EML21a2, EML22a2) zwei lichtemittierende Teilschichten (EML11a1, EML12a1, EML21a1, EML22a1, EML11a2, EML12a2, EML21a2, EML22a2) in einem Einheitspixel (PXU11, PXU12, PXU21, PXU22) beinhaltet, mindestens eine elektrische Verbindung durch eine Laserbohrposition (LDP) in der Einheitspixelgruppe ausgebildet ist, die dazu konfiguriert ist, eine Kathode mit einer darunter liegenden elektrischen Schicht zu verbinden,
die Einheitspixelgruppe eine erste, eine zweite und eine dritte lichtemittierende Schicht (EML21a1, EML12a1, EML22b, EML11c) benachbart zu der Laserbohrposition (LDP) und mindestens eine zweite und eine dritte lichtemittierende Schicht (EML11b, EML12b, EML21b, EML12c, EML21c, EML22c) beabstandet von der Laserbohrposition (LDP) umfasst,
**dadurch gekennzeichnet, dass** mindestens die zweite lichtemittierende Schicht (EML22b) und die dritte lichtemittierende Schicht (EML11c) benachbart zu der Laserbohrposition (LDP) jeweils eine Aussparung in einer Draufsicht beinhalten, die Aussparung der Laserbohrposition (LDP) in einer Draufsicht zugewandt ist,
die Größe einer Fläche der zweiten lichtemittierenden Schicht (EML22b) benachbart zu der Laserbohrposition (LDP) und die Größe einer Fläche der zweiten lichtemittierende Schicht (EML11b, EML12b, EML21b) beabstandet von der Laserbohrposition (LDP) eine Flächendifferenz von mehr als 0 % und weniger als 10 % aufweisen und
die Größe einer Fläche der dritten lichtemittierenden Schicht (EML11c) benachbart zu der Laserbohrposition (LDP) und die Größe einer Fläche der dritten lichtemittierenden Schicht (EML12c, EML21c, EML22c) beabstandet von der Laserbohrposition (LDP) eine Flächendifferenz von mehr als 0 % und weniger als 10 % aufweisen.

2. Lichtemittierende Anzeigevorrichtung nach Anspruch 1, wobei die zweite lichtemittierende Schicht (EML22b) und die dritte lichtemittierende Schicht (EML11c) benachbart zu der Laserbohrposition (LDP) aus einer zweiten modifizierten lichtemittierenden Schicht (EML22b) und einer dritten modifizierten lichtemittierenden Schicht (EML11c), die jeweils die Aussparung beinhalten, ausgebildet sind, die zweite lichtemittierende Schicht (EML11b, EML12b, EML21b) und die dritte lichtemittierende Schicht (EML 12c, EML21c, EML22c) beabstandet von der Laserbohrposition (LDP) aus einer zweiten normalen lichtemittierenden Schicht (EML11b, EML12b, EML21b) und einer dritten normalen lichtemittierenden Schicht (EML12c, EML21c, EML22c), die jeweils frei von einer Aussparung in einer Draufsicht sind, ausgebildet sind.

3. Lichtemittierende Anzeigevorrichtung nach Anspruch 2, wobei:
eine planare Form der zweiten normalen lichtemittierenden Schicht (EML11b, EML12b, EML21b) und der dritten normalen lichtemittierenden Schicht (EML 12c, EML21c, EML22c) eine Viereckform ist und Ecken abgeschrägt oder abgerundet sind.

4. Lichtemittierende Anzeigevorrichtung nach Anspruch 1, wobei:
die zweite lichtemittierende Schicht (EML11b, EML12b, EML21b) und die dritte lichtemittierende Schicht (EML 12c, EML21c, EML22c) beabstandet von der Laserbohrposition (LDP) Aussparungen aufweisen, die an einer Seite positioniert sind, die sich von einer Seite unterscheidet, an der die Aussparungen jeweils in der zweiten und dritten lichtemittierenden Schicht (EML22b, EML11c) benachbart zu der Laserbohrposition (LDP) positioniert sind.

5. Lichtemittierende Anzeigevorrichtung nach Anspruch 4, wobei:
die Einheitspixelgruppe vier Einheitspixel (PXU11, PXU12, PXU21, PXU22) beinhaltet,
die zweiten lichtemittierenden Schichten (EML11b, EML12b, EML21b, EML22b) und
die dritten lichtemittierenden Schichten (EML11c, EML12c, EML21c, EML22c) eine Rechteckform mit Ausnahme der Aussparung aufweisen und abgeschrägte oder abgerundete Ecken aufweisen,
die Einheitspixelgruppe vier zweite lichtemittierende Schichten (EML11b, EML12b, EML21b, EML22b) und vier dritte lichtemittierende Schichten (EML11c, EML12c, EML21c, EML22c) mit einer zweiten lichtemittierenden Schicht (EML22b) und einer dritten lichtemittierenden Schicht (EML11c) benachbart zu der Laserbohrposition (LDP) beinhaltet und
die Aussparungen in den zweiten lichtemittierenden Schichten (EML11b, EML12b, EML21b, EML22b) aller zweiten lichtemittierenden Schichten (EML11b, EML12b, EML21b, EML22b) an verschiedenen Ecken in Bezug aufeinander positioniert sind und/oder die Aussparungen in den dritten lichtemittierenden Schichten (EML11c, EML12c, EML21c, EML22c) aller dritten lichtemittierenden Schichten (EML11c, EML12c, EML21c, EML22c) an verschiedenen Ecken in Bezug aufeinander positioniert sind.

6. Lichtemittierend Anzeigevorrichtung nach Anspruch 1 oder 2, wobei:
die Aussparung der zweiten lichtemittierenden Schicht (EML22b) benachbart zu der Laserbohrposition (LDP) und die Aussparung der dritten lichtemittierenden Schicht (EML11c) benachbart zu der Laserbohrposition (LDP) an einer Seite der Laserbohrposition (LDP) der zweiten lichtemittierenden Schicht (EML22b) bzw. der dritten lichtemittierenden Schicht (EML11c) ausgebildet sind.

7. Lichtemittierende Anzeigevorrichtung nach Anspruch 6, wobei:
die Aussparung jeweils an einem Eckenabschnitt der zweiten lichtemittierenden Schicht (EML22b) benachbart zu der Laserbohrposition (LDP), die der Laserbohrposition (LDP) zugewandt ist, und
an einem Eckenabschnitt der dritten lichtemittierenden Schicht (EML11c) benachbart zu der Laserbohrposition (LDP), die der Laserbohrposition (LDP) zugewandt ist, ausgebildet ist.

8. Lichtemittierende Anzeigevorrichtung nach mindestens einem der Ansprüche 1 bis 7, wobei mindestens eine Aussparung oder jede Aussparung, die der Laserbohrposition (LDP) zugewandt ist, in einer Draufsicht eine konkave Form, insbesondere eine Kreisbogenform, vorzugsweise konzentrisch zu einer Mitte der Laserbohrposition (LDP) und/oder einem Außenumfang der Laserbohrposition (LDP), aufweist.

9. Lichtemittierende Anzeigevorrichtung nach mindestens einem der Ansprüche 1 bis 8, wobei: die erste lichtemittierende Schicht (EML11a1, EML12a1, EML21 a1, EML22a1, EML11a2, EML12a2, EML21a2, EML22a2) aus einer ersten normalen lichtemittierenden Schicht (EML11a1, EML12a1, EML21a1, EML22a1, EML11a2, EML12a2, EML21 a2, EML22a2) ausgebildet ist, die keine Aussparungen beinhaltet.

10. Lichtemittierende Anzeigevorrichtung nach Anspruch 9, wobei:
die erste lichtemittierende Schicht (EML11a1, EML12a1, EML21a1, EML22a1, EML11a2, EML12a2, EML21a2, EML22a2), die in einem der Einheitspixel (PXU11, PXU12, PXU21, PXU22) beinhaltet ist, eine erste-1 lichtemittierende Schicht (EML11a1, EML12a1, EML21a1, EML22a1) und eine erste-2 lichtemittierende Schicht (EML11a2, EML12a2, EML21a2, EML22a2) beinhaltet,
die erste-1 lichtemittierende Schicht (EML11a1, EML12a1, EML21a1, EML22a1) und
die erste-2 lichtemittierende Schicht (EML11a2, EML12a2, EML21a2, EML22a2) jeweils eine Rechteckform in einer Draufsicht aufweisen und abgeschrägte oder abgerundete Ecken aufweisen,
sich eine Richtung, in der die erste-1 lichtemittierende Schicht (EML11a1, EML12a1, EML21a1, EML22a1) verlängert ist, von einer Richtung unterscheidet, in der die erste-2 lichtemittierende Schicht (EML11a2, EML12a2, EML21a2, EML22a2) verlängert ist.

11. Lichtemittierende Anzeigevorrichtung nach Anspruch 10, wobei:
eine lichtemittierende Vorrichtung, die die erste-1 lichtemittierende Schicht (EML11a1, EML12a1, EML21a1, EML22a1) beinhaltet, und eine lichtemittierende Vorrichtung, die die erste-2 lichtemittierende Schicht (EML11a2, EML12a2,
EML21a2, EML22a2) beinhaltet, elektrisch mit der gleichen Pixelansteuereinheit (PCa, PCb, PCc) durch eine Verbindungsleitung (CLa, CLb) verbunden sind und in einem der Einheitspixel (PXU11, PXU12, PXU21, PXU22) beinhaltet sind.

12. Lichtemittierende Anzeigevorrichtung nach Anspruch 11, wobei:
die Laserbohrposition (LDP) in einer mittleren Fläche eines Einheitspixels (PXU11, PXU12, PXU21, PXU22) positioniert ist und sich ein Abschnitt der Verbindungsleitung (CLb) entlang einer Außenkante des Einheitspixels (PXU11, PXU12, PXU21, PXU22) erstreckt.

13. Lichtemittierende Anzeigevorrichtung nach mindestens einem der Ansprüche 1 bis 12, wobei:
eine erste lichtemittierende Schicht (EML21a1, EML12a2) benachbart zu der Laserbohrposition (LDP) als eine erste modifizierte lichtemittierende Schicht (EMLa1, EML12a2) ausgebildet ist, die eine Aussparung in einer Draufsicht beinhaltet, und
eine erste lichtemittierende Schicht (EML11a1, EML12a1, EML22a1, EML11a2, EML21a2, EML22a2) beabstandet von der Laserbohrposition (LDP) als eine erste normale lichtemittierende Schicht (EML11a1, EML12a1, EML22a1, EML11a2, EML21a2, EML22a2) ohne eine Aussparung in einer Draufsicht ausgebildet ist, die Größe einer Fläche der ersten modifizierten lichtemittierenden Schicht (EML21a1, EML12a2) und die Größe einer Fläche der ersten normalen lichtemittierenden Schicht (EML11a1, EML12a1, EML22a1, EML11a2, EML21a2, EML22a2) gleich sind oder eine Flächendifferenz von weniger als 10 % aufweisen.

14. Lichtemittierende Anzeigevorrichtung nach Anspruch 13, wobei:
die erste normale lichtemittierende Schicht (EML11a1, EML12a1, EML22a1, EML11a2, EML21a2, EML22a2) eine Rechteckform in einer Draufsicht aufweist und abgeschrägte oder abgerundete Ecken aufweist,
zwei erste modifizierte lichtemittierende Schichten (EML21a1, EML12a2) in einem Einheitspixel (PXU11, PXU12, PXU21, PXU22) beinhaltet sind und
die zwei ersten modifizierten lichtemittierenden Schichten (EML21a1, EML 12a2) länglich sind und verschiedene Richtungen aufweisen.

15. Lichtemittierende Anzeigevorrichtung nach mindestens einem der Ansprüche 2 oder 6 bis 14, wenn nicht von Anspruch 4 abhängig, wobei:
sich die zweite modifizierte lichtemittierende Schicht (EML22b) in einer geraden Linie an den Ecken, die der zweiten normalen lichtemittierenden Schicht (EML11b, EML12b, EML21b) zugewandt sind, in einer Draufsicht erstreckt und
sich die dritte modifizierte lichtemittierende Schicht in einer geraden Linie an einem Eckenabschnitt, der der dritten normalen lichtemittierenden Schicht (EML12c, EML21c, EML22c) zugewandt ist, in einer Draufsicht erstreckt.

16. Lichtemittierende Anzeigevorrichtung nach mindestens einem der Ansprüche 1 bis 15, wobei:
die Einheitspixelgruppe vier Einheitspixel (PXU11, PXU12, PXU21, PXU22) beinhaltet und
die Laserbohrposition (LDP) über allen der vier Einheitspixel (PXU11, PXU12, PXU21, PXU22) positioniert ist und wobei gegebenenfalls:
eine Mitte der Laserbohrposition (LDP) in einem der vier Einheitspixel (PXU11, PXU12, PXU21, PXU22) positioniert ist oder
eine Mitte der Laserbohrposition (LDP) an einem Punkt positioniert ist, an dem die vier Einheitspixel (PXU11, PXU12, PXU21, PXU22) aufeinandertreffen, oder wobei die Einheitspixelgruppe vier Einheitspixel (PXU11, PXU12, PXU21, PXU22) beinhaltet und
die Laserbohrposition (LDP) über einem oder zwei der vier Einheitspixel (PXU11, PXU12, PXU21, PXU22) positioniert ist.

17. Lichtemittierende Anzeigevorrichtung nach mindestens einem der Ansprüche 1 bis 16, wobei: sich die Laserbohrpositionen (LDP) in mindestens zwei verschiedenen Einheitspixelgruppen voneinander unterscheiden.

18. Lichtemittierende Anzeigevorrichtung nach mindestens einem der Ansprüche 1 bis 17, wobei ein Abstand zwischen dem Aussparungsabschnitt der dritten lichtemittierenden Schicht (EML11c) und einem Aussparungsabschnitt der zweiten lichtemittierenden Schicht (EML22b) eine Größe aufweist, die bis zu dem Zweifachen eines Abstands (Gap1) zwischen der ersten lichtemittierenden Schicht (EML11a1, EML12a1, EML21a1, EML22a1, EML11a2, EML12a2, EML21a2, EML22a2) und der dritten lichtemittierenden Schicht (EML11b, EML12b, EML21b, EML12c, EML21c, EML22c) beträgt.

## Revendications

1. Dispositif d'affichage électroluminescent, comprenant :
un groupe de pixels unitaires comportant au moins deux pixels unitaires (PXU11, PXU12, PXU21, PXU22),
dans lequel un pixel unitaire (PXU11, PXU12, PXU21, PXU22) parmi les au moins deux pixels unitaires (PXU11, PXU12, PXU21, PXU22) inclut une première couche électroluminescente (EML11a1, EML12a1, EML21a1, EML22a1, EML11a2, EML12a2, EML21a2, EML22a2), une deuxième couche électroluminescente (EML11b, EML12b, EML21b, EML22b) et une troisième couche électroluminescente (EML11c, EML12c, EML21c, EML22c) correspondant aux trois couleurs primaires,
la première couche électroluminescente (EML11a1, EML12a1, EML21a1, EML22a1, EML11a2, EML12a2, EML21a2, EML22a2) inclut deux sous-couches électroluminescentes (EML11a1, EML12a1, EML21a1, EML22a1, EML11a2, EML12a2, EML21a2, EML22a2) dans un pixel unitaire (PXU11, PXU12, PXU21, PXU22),
au moins une connexion électrique formée par une position de perçage au laser (LDP) dans le groupe de pixels unitaires, configurée pour connecter une cathode à une couche électrique sous-jacente,
le groupe de pixels unitaires comprend des première, deuxième et troisième couches électroluminescentes (EML21a1, EML12a1, EML22b, EML11c) adjacentes à la position de perçage au laser (LDP) et au moins des deuxième et troisième couches électroluminescentes (EML11b, EML12b, EML21b, EML12c, EML21c, EML22c) espacées de la position de perçage au laser (LDP),
**caractérisé en ce que**
au moins la deuxième couche électroluminescente (EML22b) et la troisième couche électroluminescente (EML11c) adjacentes à la position de perçage au laser (LDP) incluent un évidement dans une vue en plan, respectivement, l'évidement fait face à la position de perçage au laser (LDP) dans une vue en plan,
la dimension d'une aire de la deuxième couche électroluminescente (EML22b) adjacente à la position de perçage au laser (LDP) et la dimension d'une aire de la deuxième couche électroluminescente (EML11b, EML12b, EML21b) espacée de la position de perçage au laser (LDP) présentent une différence d'aire supérieure à 0 %
et inférieure à 10 %, et
la dimension d'une aire de la troisième couche électroluminescente (EML11c) adjacente à la position de perçage au laser (LDP) et la dimension d'une aire de la troisième couche électroluminescente (EML12c, EML21c, EML22c) espacée de la position de perçage au laser (LDP) présentent une différence d'aire supérieure à 0 % et inférieure à 10 %.

2. Dispositif d'affichage électroluminescent selon la revendication 1, dans lequel la deuxième couche électroluminescente (EML22b) et la troisième couche électroluminescente (EML11c) adjacentes à la position de perçage au laser (LDP) sont formées d'une deuxième couche électroluminescente modifiée (EML22b) et d'une troisième couche électroluminescente modifiée (EML11c) incluant l'évidement, respectivement,
la deuxième couche électroluminescente (EML11b, EML12b, EML21b) et la troisième couche électroluminescente (EML12c, EML21c, EML22c) espacées de la position de perçage au laser (LDP) sont formées d'une deuxième couche électroluminescente normale (EML11b, EML12b, EML21b) et d'une troisième couche électroluminescente normale (EML12c, EML21c, EML22c) qui sont exemptes d'évidement dans une vue en plan, respectivement.

3. Dispositif d'affichage électroluminescent selon la revendication 2, dans lequel :
une forme plane de la deuxième couche électroluminescente normale (EML11b, EML12b, EML21b) et de la troisième couche électroluminescente normale (EML12c, EML21c, EML22c) est une forme quadrangulaire, et des coins sont chanfreinés ou arrondis.

4. Dispositif d'affichage électroluminescent selon la revendication 1, dans lequel :
la deuxième couche électroluminescente (EML11b, EML12b, EML21b) et la troisième couche électroluminescente (EML12c, EML21c, EML22c) espacées de la position de perçage au laser (LDP) comportent des évidements positionnés sur un côté différent d'un côté sur lequel les évidements sont positionnés dans les deuxième et troisième couches électroluminescentes (EML22b, EML11c) adjacentes à la position de perçage au laser (LDP), respectivement.

5. Dispositif d'affichage électroluminescent selon la revendication 4, dans lequel :
le groupe de pixels unitaires inclut quatre pixels unitaires (PXU11, PXU12, PXU21, PXU22),
les deuxièmes couches électroluminescentes (EML11b, EML12b, EML21b, EML22b) et les troisièmes couches électroluminescentes (EML11c, EML12c, EML21c, EML22c) ont une forme rectangulaire à l'exception de l'évidement, et comportent des coins chanfreinés ou arrondis,
le groupe de pixels unitaires inclut quatre deuxièmes couches électroluminescentes (EML11b, EML12b, EML21b, EML22b) et quatre troisièmes couches électroluminescentes (EML11c, EML12c, EML21c, EML22c) avec une deuxième couche électroluminescente (EML22b) et une troisième couche électroluminescente (EML11c) adjacentes à la position de perçage au laser (LDP), et les évidements dans les deuxièmes couches électroluminescentes (EML11b, EML12b, EML21b, EML22b) de toutes les deuxièmes couches électroluminescentes (EML11b, EML12b, EML21b, EML22b) sont positionnés à des coins différents les uns par rapport aux autres et/ou les évidements dans les troisièmes couches électroluminescentes (EML11c, EML12c, EML21c, EML22c) de toutes les troisièmes couches électroluminescentes (EML11c, EML12c, EML21c, EML22c) sont positionnés à des coins différents les uns par rapport aux autres.

6. Dispositif d'affichage électroluminescent selon la revendication 1 ou 2, dans lequel : l'évidement de la deuxième couche électroluminescente (EML22b) adjacente à la position de perçage au laser (LDP) et l'évidement de la troisième couche électroluminescente (EML11c) adjacente à la position de perçage au laser (LDP) sont formés au niveau d'un côté de la position de perçage au laser (LDP) de la deuxième couche électroluminescente (EML22b) et de la troisième couche électroluminescente (EML11c), respectivement.

7. Dispositif d'affichage électroluminescent selon la revendication 6, dans lequel :
l'évidement est formé respectivement au niveau d'une portion de coin de la deuxième couche électroluminescente (EML22b) adjacente à la position de perçage au laser (LDP), faisant face à la position de perçage au laser (LDP), et
au niveau d'une portion de coin de la troisième couche électroluminescente (EML11c) adjacente à la position de perçage au laser (LDP), faisant face à la position de perçage au laser (LDP).

8. Dispositif d'affichage électroluminescent selon au moins l'une des revendications 1 à 7, dans lequel au moins un évidement ou chaque évidement faisant face à la position de perçage au laser (LDP) a une forme concave, notamment une forme d'arc de cercle, de préférence concentrique à un centre de la position de perçage au laser (LDP) et/ou à une circonférence externe de la position de perçage au laser (LDP), dans une vue en plan.

9. Dispositif d'affichage électroluminescent selon au moins l'une des revendications 1 à 8, dans lequel :
la première couche électroluminescente (EML11a1, EML12a1, EML21a1, EML22a1, EML11a2, EML12a2, EML21a2, EML22a2) est formée d'une première couche électroluminescente normale (EML11a1, EML12a1, EML21a1, EML22a1, EML11a2, EML12a2, EML21a2, EML22a2) qui n'inclut pas d'évidements.

10. Dispositif d'affichage électroluminescent selon la revendication 9, dans lequel :
la première couche électroluminescente (EML11a1, EML12a1, EML21a1, EML22a1, EML11a2, EML12a2, EML21a2, EML22a2) incluse dans l'un des pixels unitaires (PXU11, PXU12, PXU21, PXU22) inclut une première-1 couche électroluminescente (EML11a1, EML12a1, EML21a1, EML22a1) et une première-2 couche électroluminescente (EML11a2, EML12a2, EML21a2, EML22a2),
la première-1 couche électroluminescente (EML11a1, EML12a1, EML21a1, EML22a1) et la première-2 couche électroluminescente (EML11a2, EML12a2, EML21a2, EML22a2) ont chacune une forme rectangulaire dans une vue en plan et comportent des coins chanfreinés ou arrondis,
une direction dans laquelle la première-1 couche électroluminescente (EML11a1, EML12a1, EML21a1, EML22a1) est allongée est différente d'une direction dans laquelle la première-2 couche électroluminescente (EML11a2, EML12a2, EML21a2, EML22a2) est allongée.

11. Dispositif d'affichage électroluminescent selon la revendication 10, dans lequel :
un dispositif électroluminescent incluant la première-1 couche électroluminescente (EML11a1, EML12a1, EML21a1, EML22a1) et un dispositif électroluminescent incluant la première-2 couche électroluminescente (EML11a2, EML12a2, EML21a2, EML22a2) sont connectés électriquement à la même unité de pilotage de pixels (PCa, PCb, PCc) par l'intermédiaire d'une ligne de connexion (CLa, CLb), et sont inclus dans l'un des pixels unitaires (PXU11, PXU12, PXU21, PXU22).

12. Dispositif d'affichage électroluminescent selon la revendication 11, dans lequel :
la position de perçage au laser (LDP) est positionnée dans une aire centrale d'un pixel unitaire (PXU11, PXU12, PXU21, PXU22), et une portion de la ligne de connexion (CLb) s'étend le long d'un bord externe du pixel unitaire (PXU11, PXU12, PXU21, PXU22).

13. Dispositif d'affichage électroluminescent selon au moins l'une des revendications 1 à 12, dans lequel :
une première couche électroluminescente (EML21a1, EML12a2) adjacente à la position de perçage au laser (LDP) est formée en tant que première couche électroluminescente modifiée (EML21a1, EML12a2) incluant un évidement dans une vue en plan, et une première couche électroluminescente (EML11a1, EML12a1, EML22a1, EML11a2, EML21a2, EML22a2) espacée de la position de perçage au laser (LDP) est formée en tant que première couche électroluminescente normale (EML11a1, EML12a1, EML22a1, EML11a2, EML21a2, EML22a2) sans évidement dans une vue en plan,
la dimension d'une aire de la première couche électroluminescente modifiée (EML21a1, EML12a2) et la dimension d'une aire de la première couche électroluminescente normale (EML11a1, EML12a1, EML22a1, EML11a2, EML21a2, EML22a2) sont identiques ou présentent une différence d'aire inférieure à 10 %.

14. Dispositif d'affichage électroluminescent selon la revendication 13, dans lequel :
la première couche électroluminescente normale (EML11a1, EML12a1, EML22a1, EML11a2, EML21a2, EML22a2) a une forme rectangulaire dans une vue en plan, et comporte des coins chanfreinés ou arrondis,
deux premières couches électroluminescentes modifiées (EML21a1, EML12a2) sont incluses dans un pixel unitaire (PXU11, PXU12, PXU21, PXU22), et
les deux premières couches électroluminescentes modifiées (EML21a1, EML12a2) sont allongées et ont des directions différentes.

15. Dispositif d'affichage électroluminescent selon au moins l'une des revendications 2 ou 6 à 14, lorsqu'elle ne dépend pas de la revendication 4, dans lequel :
la deuxième couche électroluminescente modifiée (EML22b) s'étend en ligne droite au niveau des coins faisant face à la deuxième couche électroluminescente normale (EML11b, EML12b, EML21b), dans une vue en plan, et
la troisième couche électroluminescente modifiée s'étend en ligne droite au niveau d'une portion de coin faisant face à la troisième couche électroluminescente normale (EML12c, EML21c, EML22c), dans une vue en plan.

16. Dispositif d'affichage électroluminescent selon au moins l'une des revendications 1 à 15, dans lequel :
le groupe de pixels unitaires inclut quatre pixels unitaires (PXU11, PXU12, PXU21, PXU22), et
la position de perçage au laser (LDP) est positionnée au-dessus de l'ensemble des quatre pixels unitaires (PXU11, PXU12, PXU21, PXU22) et facultativement, dans lequel :
un centre de la position de perçage au laser (LDP) est positionné dans l'un des quatre pixels unitaires (PXU11, PXU12, PXU21, PXU22), ou
un centre de la position de perçage au laser (LDP) est positionné en un point où les quatre pixels unitaires (PXU11, PXU12, PXU21, PXU22) se rejoignent, ou dans lequel le groupe de pixels unitaires inclut quatre pixels unitaires (PXU11, PXU12, PXU21, PXU22), et
la position de perçage au laser (LDP) est positionnée sur un ou deux des quatre pixels unitaires (PXU11, PXU12, PXU21, PXU22).

17. Dispositif d'affichage électroluminescent selon au moins l'une des revendications 1 à 16, dans lequel :
les positions de perçage au laser (LDP) sont différentes les unes des autres dans au moins deux groupes de pixels unitaires différents.

18. Dispositif d'affichage électroluminescent selon au moins l'une des revendications 1 à 17, dans lequel une distance entre la portion d'évidement de la troisième couche électroluminescente (EML11c) et une portion d'évidement de la deuxième couche électroluminescente (EML22b) a une dimension qui peut aller jusqu'au double de celle d'une distance (Gap1) entre la première couche électroluminescente (EML11a1, EML12a1, EML21a1, EML22a1, EML11a2, EML12a2, EML21a2, EML22a2) et la troisième couche électroluminescente (EML11b, EML12b, EML21b, EML12c, EML21c, EML22c).
